# EUROPEAN PATENT APPLICATION

(11) **EP 4 661 085 A1**
(43) Date of publication of application: **10.12.2025**
(21) Application number: 24749891.8
(22) Date of filing: 11.01.2024
(51) Int. Cl.: H01L 33/62, G02F 1/13357, H01L 33/50

(54) **LIGHT EMITTING DEVICE AND DISPLAY DEVICE**

(30) Priority: 31.01.2023 JP 2023012930
(71) Applicant: Sony Group Corporation, Tokyo 108-0075 (JP)
(72) Inventor: AKASAKA, Shin, Tokyo 108-0075 (JP); ARAKI, Soya, Tokyo 108-0075 (JP)
(74) Representative: 2SPL Patentanwälte PartG mbB
(86) International application number: PCT/JP2024/000459
(87) International publication number: WO 2024/161935

(57) **Abstract**

Provided is a light emitting device exhibiting excellent light emission performance. The light emitting device includes multiple light source units and one relay sheet member. The multiple light source units each include one light source substrate and one or more light sources provided on the light source substrate. The one relay sheet member supports each of the multiple light source units and is electrically coupled to each of the multiple light source units.

## Description

### Technical Field

The present disclosure relates to a light emitting device suitable for a surface light source, and a display device, which performs image display by using illumination light from the light emitting device.

### Background Art

A light source device has been used so far, which uses an LED (light emitting diode) as a light source, serving as a backlight of a liquid crystal display device (for example, see Patent Literatures 1 and 2).

### Citation List

### Patent Literature

Patent Literature 1: Japanese Unexamined Patent Application Publication No. 2012-203997
Patent Literature 2: Description of International Publication No. 2020-039721

### Summary of the Invention

Meanwhile, recently, it is required to provide a light emitting device, which realizes high-definition luminance distribution, by highly integrating a plurality of light sources.

Therefore, it is desired to provide a light emitting device configured to exhibit excellent light emission performance, and a display device provided therewith.

A light emitting device according to an embodiment of the present disclosure includes multiple light source units and one relay sheet member. The multiple light source units each include one light source substrate, and one or more light sources provided on the light source substrate. The one relay sheet member supports each of the multiple light source units, and is electrically coupled to each of the multiple light source units.

According to the light emitting device according to an embodiment of the present disclosure, each of the multiple light source units is supported by the one relay sheet member, and each of the multiple light source units is electrically coupled to the one relay sheet member. Thus, it is advantageous to reduce the total thickness and weight. Moreover, because it is possible to finely adjust position arrangement of each of the multiple light source units, optimization of position arrangement of each of the light sources may be accomplished easily.

### Brief Description of the Drawings

[FIG. 1A] FIG. 1A is a first perspective view illustrating an appearance of a light emitting device according to a first embodiment of the present disclosure, as viewed in a first direction.
[FIG. 1B] FIG. 1B is a second perspective view illustrating an appearance of the light emitting device shown in FIG. 1A, as viewed in a second direction.
[FIG. 2A] FIG. 2A is a plan view illustrating a plan configuration of a relay film member of the light emitting device shown in FIG. 1A.
[FIG. 2B] FIG. 2B is a plan view illustrating a plan layout of multiple light source units of the light emitting device shown in FIG. 1A.
[FIG. 3] FIG. 3 is a cross-sectional view illustrating a cross-sectional configuration of a part of the light emitting device shown in FIG. 1A.
[FIG. 4] FIG. 4 is an expanded cross-sectional view illustrating an example of configuration of a light source shown in FIG. 1.
[FIG. 5] FIG. 5 is an expanded cross-sectional view expansively illustrating an example of detailed configuration of a coupling member shown in FIG. 3.
[FIG. 6A] FIG. 6A is a first cross-sectional view illustrating a forming process of the coupling member shown in FIG. 5.
[FIG. 6B] FIG. 6B is a second cross-sectional view illustrating the forming process of the coupling member shown in FIG. 5.
[FIG. 6C] FIG. 6C is a third cross-sectional view illustrating the forming process of the coupling member shown in FIG. 5.
[FIG. 7] FIG. 7 is a plan view illustrating an example of configuration of the light emitting device according to a first modification example of the first embodiment.
[FIG. 8] FIG. 8 is a plan view illustrating an example of configuration of the light emitting device according to a second modification example of the first embodiment.
[FIG. 9] FIG. 9 is a plan view illustrating an example of configuration of the light emitting device according to a third modification example of the first embodiment.
[FIG. 10] FIG. 10 is a plan view illustrating an example of configuration of the light emitting device according to a first modification example of the first embodiment.
[FIG. 11A] FIG. 11A is a plan view illustrating an example of configuration of the light source unit according to a fifth modification example of the first embodiment.
[FIG. 11B] FIG. 11B is a cross-sectional view illustrating an example of configuration of the light source unit according to a sixth modification example of the first embodiment.
[FIG. 11C] FIG. 11C is a plan view illustrating an example of configuration of the light emitting device according to a seventh modification example of the first embodiment.
[FIG. 11D] FIG. 11D is a plan view illustrating an example of configuration of the light emitting device according to an eighth modification example of the first embodiment.
[FIG. 11E] FIG. 11E is a plan view illustrating an example of configuration of the light source unit according to a ninth modification example of the first embodiment.
[FIG. 12] FIG. 12 is a cross-sectional view illustrating an example of configuration of the light emitting device according to a tenth modification example of the first embodiment.
[FIG. 13] FIG. 13 is a schematic view illustrating an appearance of a display device according to a second embodiment of the present disclosure.
[FIG. 14] FIG. 14 is a perspective view illustrating a disassembled main body shown in FIG. 13.
[FIG. 15] FIG. 15 is a perspective view illustrating a disassembled panel module shown in FIG. 14.
[FIG. 16] FIG. 16 is a schematic plan view illustrating an example of plan configuration of the panel module shown in FIG. 14.
[FIG. 17] FIG. 17 is a schematic plan view illustrating an example of plan configuration of the panel module according to a first modification example of the second embodiment.
[FIG. 18] FIG. 18 is a schematic plan view illustrating an example of plan configuration of the panel module according to a second modification example of the second embodiment.
[FIG. 19] FIG. 19 is a schematic plan view illustrating an example of plan configuration of the panel module according to a third modification example of the second embodiment.
[FIG. 20] FIG. 20 is a cross-sectional view illustrating an example of configuration of the light emitting device according to another first modification example of the present disclosure.
[FIG. 21] FIG. 21 is a cross-sectional view illustrating an example of configuration of the light emitting device according to another second modification example of the present disclosure.
[FIG. 22] FIG. 22 is a cross-sectional view illustrating an example of configuration of the light emitting device according to another third modification example of the present disclosure.
[FIG. 23] FIG. 23 is a cross-sectional view illustrating an example of configuration of the light emitting device according to another fourth modification example of the present disclosure.
[FIG. 24] FIG. 24 is a cross-sectional view illustrating an example of configuration of the light emitting device according to another fifth modification example of the present disclosure.
[FIG. 25] FIG. 25 is a cross-sectional view illustrating an example of configuration of the light emitting device according to another sixth modification example of the present disclosure.
[FIG. 26] FIG. 26 is a perspective view illustrating an example of configuration of the display device according to another seventh modification example of the present disclosure.

### Modes for Carrying Out the Invention

Hereinafter, embodiments for practicing the present disclosure will be described in detail with reference to the drawings. It is to be noted that description is given in the following order:
1. First Embodiment (Light Emitting Device);
2. Second Embodiment (Liquid Crystal Display Device);
3. Other Modification Examples.

### <1. First Embodiment>

### [1.1 Configuration]

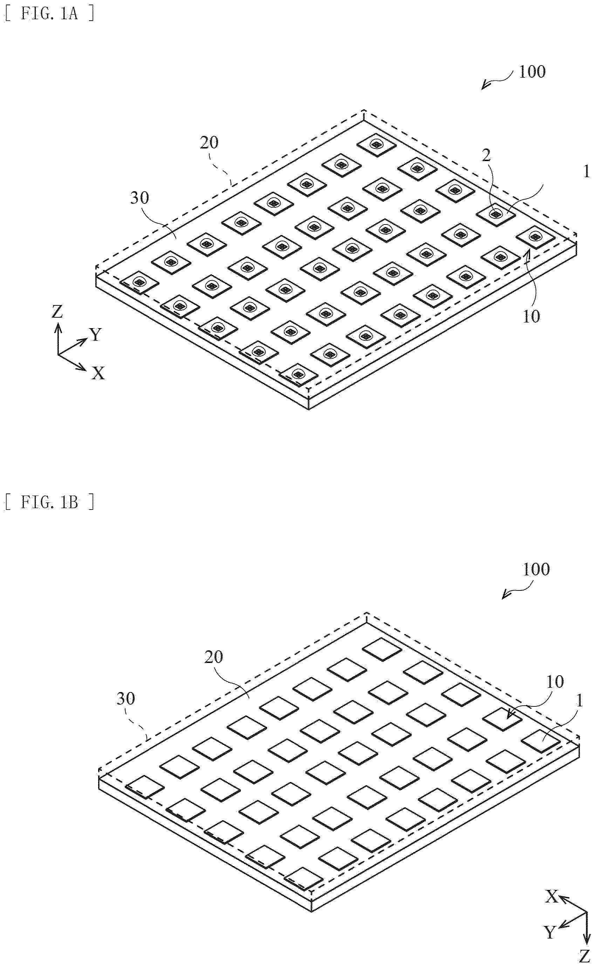

FIG. 1A and FIG. 1B are both perspective views illustrating an example of configuration of a light emitting device 100 according to a first embodiment of the present disclosure. The light emitting device 100 is suitable for a surface light source, and used for a direct-type backlight, which is mounted, for example, in a liquid crystal display device. FIG. 1A and FIG. 1B illustrate appearances of the light emitting device 100, as viewed in opposite directions to each other. Specifically, FIG. 1A illustrates the appearance of the light emitting device 100 as viewed from a side of a light emitting surface, and FIG. 1B illustrates the appearance of the light emitting device 100 as viewed from a side of a back surface, which is a side opposite to the light emitting surface.

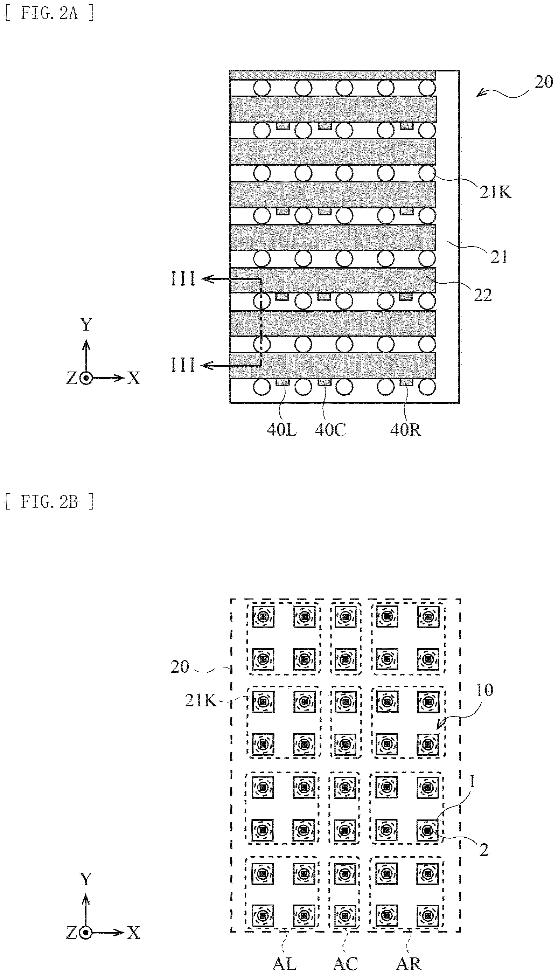

FIG. 2A and FIG. 2B are both plan views illustrating plan configurations of the light emitting device 100 shown in FIG. 1A and FIG. 1B. More in details, FIG. 2A schematically illustrates a plan configuration of a relay sheet member 20, which will be described afterwards, and FIG. 2B schematically illustrates a plan layout of multiple light source units 10, which will be described afterwards

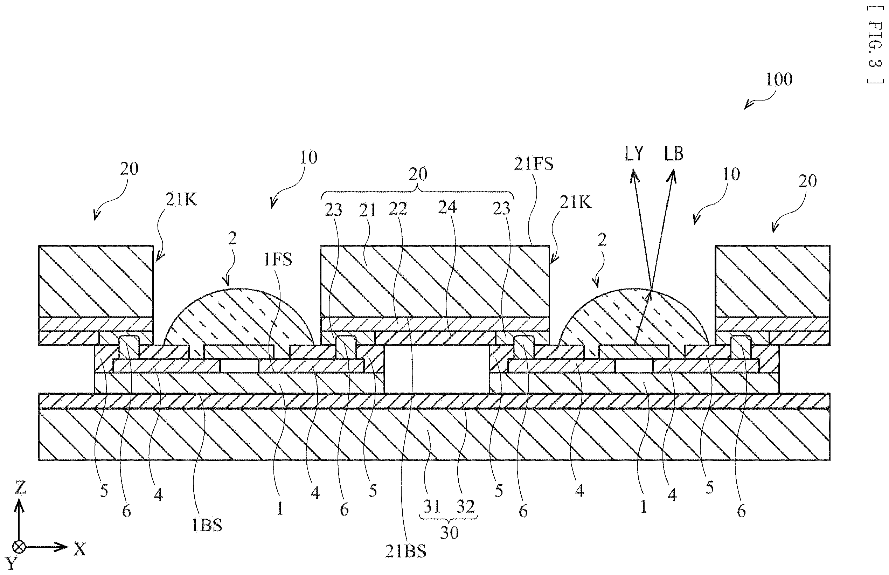

Furthermore, FIG. 3 is a cross-sectional view illustrating a cross-sectional configuration of a part of the light emitting device 100 shown in FIG. 1A and FIG. 1B. Note that, FIG. 3 illustrates a cross section as viewed in directions of arrows along cutting lines III-III of FIG. 2A.

The light emitting device 100 includes, for example, multiple light source units 10, one relay sheet member 20, and one protection sheet member 30. As illustrated in FIG. 1A to FIG. 2B, the multiple light source units 10 are arranged, to be aligned both in an X-axis direction and a Y-axis direction, and furthermore, discretely to be separated from each other. Note that intervals between the multiple light source units 10 adjacent to each other, are not limited to be constant intervals, and may be set arbitrarily as desired. In contrast, the one relay sheet member 20 and the one protection sheet member 30 are extending both in the X-axis direction and the Y-axis direction, to include parts which are joined to each of the multiple light source units 10. The relay sheet member 20 is mechanically joined to each of the multiple light source units 10. Thus, the relay sheet member 20 supports each of the multiple light source units 10. Furthermore, the relay sheet member 20 is also electrically coupled to each of the multiple light source units 10.

Note that, in FIG. 1A, for the purpose of securing visibility of the multiple light source units 10, the relay sheet member 20 is shown by broken lines. Moreover, in FIG. 1B, for the purpose of securing visibility of the multiple light source units 10, the protection sheet member 30 is shown by broken lines. Moreover, in FIG. 2A and FIG. 2B, the representation of the protection sheet member 30 is omitted.

As illustrated in FIG. 1A, each of the light source units 10 includes one light source substrate 1 and one light source 2. As illustrated in FIG. 3, the light source substrate 1 includes a front surface 1FS and a back surface 1BS on a side opposite to the front surface 1FS in a thickness direction (a Z-axis direction). The plurality of light sources 2 is provided on the front surface 1FS of the light source substrate 1 (FIG. 3). The plurality of light sources 2 is aligned, for example in a single row at predetermined intervals in the X-axis direction, which is a longitudinal direction of the light source substrate 1. The relay sheet member 20 is provided on the side of the front surface 1FS of each of the plurality of light source substrates 1. The relay sheet member 20 is joined to each of the front surfaces 1FS of the plurality of light source substrates 1, for example by conductive coupling members 6. Moreover, the protection sheet member 30 extends in an X-Y plane, and is provided on the side of each of the back surfaces 1BS of the plurality of light source substrates 1, to cover the multiple light source units 10 entirely. It is preferable that the protection sheet member 30 is joined to each of the back surfaces 1BS of the plurality of light source substrates 1, for example by adhesion.

As illustrated in FIG. 2A, the light emitting device 100 further includes drivers 40C, 40L, and 40R. The drivers 40C, 40L, and 40R are substantially the same structural elements, except for the arrangement positions. Therefore, in the explanation hereinafter, the drivers 40C, 40L, and 40R will sometimes be referred to as a driver 40 collectively. As illustrated in FIG. 2A, the driver 40 may be provided, for example, on the relay sheet member 20. Alternatively, the driver 40 may be provided on the light source substrate 1 of each of the light source units 10. Moreover, the driver 40 may be provided both on the relay sheet member 20 and the light source substrate 1 of the light source unit 10.

### (Light Source Unit 10)

As illustrated in FIG. 3, each of the multiple light source units 10 includes the light source substrate 1, the plurality of light sources 2, a wiring 4, and a resin layer 5. The light source substrate 1 is, for example, a film-shaped member made of resin, having electric insulation properties, and it is preferable to have flexibility. For example, PI (polyimide), PET (polyethylene terephthalate), PC (polycarbonate), PEN (polyethylene naphthalate), PEI (polyetherimide), LCP (liquid crystal polymer), or a film made of resin, such as fluororesin, may be used for the light source substrate 1. Alternatively, it is possible to use material, in which a polyimide or epoxy-based insulative resin layer has been formed on a surface of a metal-based substrate, such as aluminum (Al), as the light source substrate 1. Furthermore, it is also possible to use a film base material containing glass-inclusive resin (such as glass epoxy resin represented by FR4, or glass composite resin represented by CEM3) as the light source substrate 1. The plurality of wirings 4 and the plurality of light sources 2 are mounted on the front surface 1FS of the light source substrate 1. Moreover, the wirings 4 are covered by the resin layer 5, except for some of the wirings 4. Furthermore, each of the coupling members 6 erects on a corresponding part of region of each of the plurality of wirings 4. Each of the plurality of wirings 4 is electrically coupled to the relay sheet member 20 via the coupling member 6.

### (Light Source 2 and Wiring 4)

The plurality of light sources 2 is provided on the front surface 1FS of the light source substrate 1. The plurality of wirings 4 in a predetermined pattern shape is formed on the front surface 1FS of the light source substrate 1, configured to perform light emission control independently for each of one or more light sources 2. With the plurality of wirings 4, it is possible to perform local light emission control (local dimming) of the plurality of light sources 2. The light emitting device 100 is configured to control light emitting intensity and lighting timing, for example per unit region A (in FIG. 2B, described as AL, AC, and AR) shown by broken lines in FIG. 2, by the drivers 40 (in FIG. 2A, described as 40L, 40C, and 40R). The driver 40 is a driver IC for driving, that is, for turning ON and OFF, of each of the light sources 2. In a configuration example as illustrated in FIG. 2A and FIG. 2B, the plurality of light sources 2 provided in the unit region AL is coupled to the driver 40L by the wiring 4 (FIG. 3) and a wiring 22 (described afterwards). Moreover, in a configuration example as illustrated in FIG. 2A and FIG. 2B, the plurality of light sources 2 provided in the unit region AC is coupled to the driver 40C by the wiring 4 (FIG. 3) and the wiring 22 (described afterwards). Furthermore, in a configuration example as illustrated in FIG. 2A and FIG. 2B, the plurality of light sources 2 provided in the unit region AR is coupled to the driver 40R by the wiring 4 (FIG. 3) and the wiring 22 (described afterwards). The driver 40L is configured to drive, for example, four light sources 2 provided in the unit region AL, among the plurality of light sources 2. The driver 40C is configured to drive, for example, four light sources 2 provided in the unit region AL, among the plurality of light sources 2. The driver 40R is configured to drive, for example, four light sources 2 provided in the unit region AR, among the plurality of light sources 2. Note that, in the example as illustrated in FIG. 2, four light sources 2 are arranged in a single unit region A (AL, AC, AR), but the present disclosure is not limited to this example. The number of light sources 2 contained in the single unit region A (AL, AC, AR) may be one to three, or may be five or more. Moreover, in the present disclosure, a layout of the plurality of unit regions AR is not limited to the layout as illustrated in FIG. 2B.

The wiring 4 is patterned by using a photolithography method, after laminating, for example, a copper foil to the light source substrate 1. Alternatively, the wiring 4 may be patterned by using the photolithography method, after forming a metal film on the light source substrate 1 by using plating or vacuum deposition film forming technology. Furthermore, the wiring 4 may be formed by printing, such as screen printing or ink-jet printing. As material for the wiring 4, for example, copper (Cu), aluminum (Al), or silver (Ag), or their alloys may be used.

### (Resin Layer 5)

The resin layer 5 is, for example, a white resist layer. The resin layer 5 has relatively a high reflectance for light emitted from the light source 2. As an example of white resist, inorganic materials such as titanium dioxide (TiO₂) fine particles or barium sulfate (BaSO₄) fine particles, or porous acrylic resin fine particles having countless pores for light scattering, or organic materials such as polycarbonate resin fine particles, may be used. As material for the resin layer 5, epoxy resin may also be used. Furthermore, the resin layer 5 may be made of resin containing inorganic fine particles, such as titanium dioxide (TiO₂) fine particles or barium sulfate (BaSO₄) fine particles. Note that, the relay sheet member 20 is boned to the surface of the resin layer 5 by adhesion, etc., in regions other than the region in which the light source 2 is provided.

### (Details of Light Source 2)

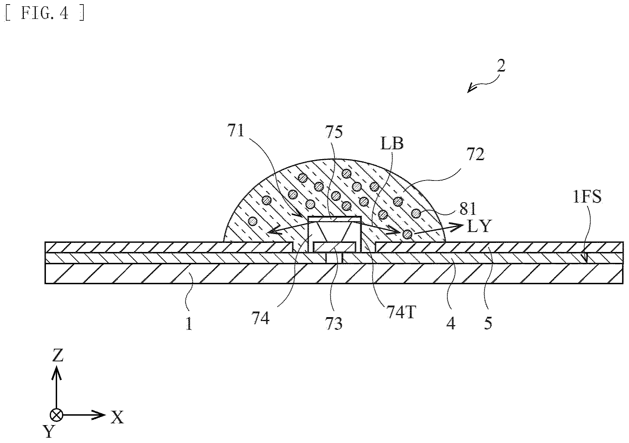

FIG. 4 is an expanded cross-sectional view illustrating an example of configuration of the light source 2 shown in FIG. 1. As illustrated in FIG. 4, the light source 2 is a so-called direct-potting-type of light source, and includes a light emitting element 71 and a sealing lens 72. The light emitting element 71 includes, for example, a semiconductor layer 73 containing a light emitting body, and a reflective layer 75 arranged to face the semiconductor layer 73 in the Z-axis direction via a transparent layer 74.

The transparent layer 74 is made, for example, of sapphire or silicon carbide. The semiconductor layer 73 is formed by stacking, for example, an n-type semiconductor layer, an active layer, and a p-type semiconductor layer, from the side of the transparent layer 74 in that order. The n-type semiconductor layer is formed, for example, by an n-type nitride semiconductor (for example, n-type GaN). The active layer formed, for example, by a nitride semiconductor having a quantum well structure (for example, n-type GaN). The p-type semiconductor layer is formed, for example, by a p-type nitride semiconductor (for example, p-type GaN). The semiconductor layer 73 is formed, for example, a blue LED (light emitting diode) emitting blue light (for example, wavelength of 440 nm to 460 nm). The reflective layer 75 is provided on a side of the transparent layer 74 opposite to the semiconductor layer 73. The reflective layer 75 is made of material having a high reflectance. The reflective layer 75 is made, specifically, of silver vapor film, aluminum vapor film, or multi-layer reflective film, etc. As an example of multi-layer reflective film, DBR (distributed bragg reflector) may be used.

As illustrated in FIG. 4, with regard to the light emitting element 71, light LB, which has been emitted from the active layer of the semiconductor layer 73, is reflected by the reflective layer 75, and thereafter, enters the sealing lens 72 from an end surface 74T of the transparent layer 74. The light LB, which entered the sealing lens 72, is configured to be transmitted through the sealing lens 72 and emitted to a surrounding region. Note that, the light LB is subject to optical effects while being transmitted through the sealing lens 72.

The sealing lens 72 is an optical member made of transparent resin, such as silicone or acrylic. The sealing lens 72 is configured to cover the light emitting element 71 entirely, to seal the light emitting element 71. The sealing lens 72 has a refractive index, between the refractive index of the semiconductor layer 73 of the light emitting element 71, and the refractive index of air. The sealing lens serves to protect the light emitting element 71, and furthermore, to improve extraction efficiency of light emitted from the light emitting element 71. An external shape of the sealing lens 72 is not limited, as long as optical effects, as a lens for extracting the light LB emitted from the light emitting element 71, are secured. For example, the external shape of the sealing lens 72 is not limited to a shape containing a spherical surface, and it is possible to use a shape containing an aspherical surface. Moreover, the sealing lens 72 may also be configured to control a light distribution direction of the light LB emitted from the light emitting element 71.

Because of the direct potting structure of the light source 2, it is easy to form the sealing lens 72 to be in a shape of dome, of which aspect ratio is not less than 0.2 and not more than 1. In a case where the sealing lens 72 is in a shape of dome, in particular between 0.4 to 0.6, luminance uniformity characteristics, such as luminance unevenness, may be improved. Here, the aspect ratio is the ratio of the height h and the radius r of the dome-shaped lens, namely, h/r. The aspect ratio 1 means a hemispherical shape.

Moreover, the sealing lens 72 may include, for example, a wavelength conversion member 81 in the form of particles. The wavelength conversion member 81 includes, for example, a fluorescent body (fluorescent substance) such as a fluorescent pigment or a fluorescent dye, or quantum dots, etc., and is excited by light from the light source 2, and converts the light from the light source 2 into light at another wavelength that is different from the original wavelength, and emits the light, by the principle of fluorescent luminescence, etc. Note that, although the wavelength conversion member 81 is expressed as a particle for simplification purposes in FIG. 4, the wavelength conversion member 81 of the present disclosure is not limited to be in the particle shape.

The wavelength conversion member 81 absorbs the blue light LB emitted from the semiconductor layer 73 of the light source 2, and converts the light partially to red light (for example, wavelength of 620 nm to 750 nm) or green light (for example, wavelength of 495 nm to 570 nm). In this case, the blue light LB from the semiconductor layer 73 passes through the sealing lens 72 containing the wavelength conversion member 81, and consequently, the red light, the green light, and the blue light are synthesized to generate white light. Alternatively, the wavelength conversion member 81 contained in the sealing lens 72 may be configured to absorb the blue light and to partially convert the light into yellow light. In this case, the light from the light source 2 passes through the sealing lens 72, and consequently, the yellow light and the blue light are synthesized to generate white light. Therefore, the light source 2 may be referred to as a white light source.

The wavelength conversion member 81 may preferably contain quantum dots. The quantum dot is a particle, of which long diameter is approximately 1 nm to 100 nm, and has a discrete energy level. Because the energy state of quantum dot depends on its size, it is possible to select a light emitting wavelength freely by varying the size. Moreover, light emitted from the quantum dot has a narrow spectral width. By combining these sharp-peak types of light, the color gamut will expand. Therefore, by using the quantum dots as the wavelength conversion member, it is possible to expand the color gamut easily. Furthermore, the quantum dot has a high response, and it is possible to use the light from the light source 2 efficiently. In addition, the quantum dot has a high stability. The quantum dot is, for example, a compound of Group 12 and Group 16 elements, a compound of Group 13 and Group 16 elements, or a compound of Group 14 and Group 16 elements, such as CdSe, CdTe, ZnS, CdS, PbS, PbSe, or CdHgTe. Moreover, because of demand for Cd-free quantum dots under the environmental regulations such as the RoHS Directive, etc., the core material may include InP-based, CsPbBr3-based perovskite, Zn (Te, Se), or silver indium sulfide, which is one of I-III-VI Group ternary system.

### (Relay Sheet Member 20)

The relay sheet member 20 is a member, which electrically and mechanically couples the multiple light source units 10 to each other, and relays the multiple light source units 10 to power supply circuits and driving circuits. The relay sheet member 20 may be preferably made, for example, of a flexible film member. The relay sheet member 20 is provided for the multiple light source units 10 in common. As described above, the relay sheet member 20 is joined to the front surface 1FS of the light source substrate 1 of each of the multiple light source units 10. More in detail, the relay sheet member 20 is provided in a region of the front surface 1FS of the light source substrate 1, which is the region other than the region in which the light source 2 is provided. The relay sheet member 20 includes a plurality of apertures 21K. As illustrated in FIG. 2A to FIG. 3, each of the plurality of apertures 21K is provided at a position overlapping with the light source 2 of each of the light source units 10, in a thickness direction orthogonal to the front surface 1FS (Z-axis direction). The aperture 21K is a through hole for disposing the light source 2, and the resin layer 5 is exposed in a region in which the aperture 21K is formed, and the exposed resin layer 5 is covered by the sealing lens 72 of the light source 2. The relay sheet member 20 is joined to the surface of the resin layer 5 extending in the X-Y plane.

As illustrated in FIG. 3. the relay sheet member 20 includes a base material 21, a wiring 22, a coupling part 23, and an insulation film 24.

The base material 21 is a reflective sheet, serving as a reflective layer that reflects light from the one or more light sources 2 of each of the multiple light source units 10. The base material 21 has a high reflectance, for example, for the light LB from the light source 2, and light LY, of which wavelength has been converted by the wavelength conversion member 81. The base material 21 may contain titanium dioxide or Ag (silver) as a high reflectance material. Specifically, the base material 21 is, for example, a white resist layer. As an example of white resist, inorganic materials such as titanium dioxide (TiO₂) fine particles or barium sulfate (BaSO₄) fine particles, or porous acrylic resin fine particles having countless pores for light scattering, or organic materials such as polycarbonate resin fine particles, may be used. As material for the base material 21, epoxy resin may also be used. Furthermore, the base material 21 may be made of resin containing inorganic fine particles, such as titanium dioxide (TiO₂) fine particles or barium sulfate (BaSO₄) fine particles.

Thus, because the base material 21 is a reflective sheet, in regard to the light LB and the light LY, the base material 21 reflects returning light, that is the light reflected in front of the relay sheet member 20, in other words, the light reflected by another member such as a light diffusion sheet provided on a side opposite to the light source substrate 1 as viewed from the relay sheet member 20, and the returning light is used as a recycled light for generating white light. Accordingly, it is possible to improve luminance of the light emitting device 100 in total.

The wiring 22 is provided selectively on a part of a back surface 21BS of the base material 21, which opposes to the front surface 1FS of the light source substrate. The wiring 22 is patterned by using a photolithography method, after laminating, for example, a copper foil to back surface 21BS of the base material 21. Alternatively, the wiring 22 may be patterned by using the photolithography method, after forming a metal film on the back surface 21BS of the base material 21 by using plating or vacuum deposition film forming technology. Furthermore, the wiring 22 may be formed by printing, such as screen printing or ink-jet printing. As material for the wiring 22, for example, copper (Cu), aluminum (Al), or silver (Ag), or their alloys may be used. The coupling part 23 is a conductive pad, provided on a side opposite to the base material 21 as viewed from the wiring 22, to cover a part of the wiring 22.

The insulation film 24 may preferably be provided to cover a part of the wiring 22, that is the part other than that covered by the coupling part 23. This is because, by serving as a protective film for the wiring 22 to reduce opportunity to be in contact with outer air or moisture, it is possible to prevent deterioration in the wiring 22, such as oxidation or degrading.

Moreover, the relay sheet member 20 is joined to the multiple light source units 10 via the conductive coupling members 6. Specifically, as illustrated in FIG. 3, for example, the coupling part 23 and the wiring 4 of the light source unit 10, facing each other in the Z-axis direction, are coupled to each other by sandwiching the coupling member 6. Note that, the relay sheet member 20 is joined, for example, to a part of a peripheral region of the light source substrate 1, surrounding the light source 2 in the X-Y plane. Moreover, each of the light source units 10 may be joined to the relay sheet member 20 at multiple points, via the coupling members 6. In this case, each of the light source units 10 is held to the relay sheet member 20 more stably. Moreover, because a plurality of channels between each of the light source units 10 and the relay sheet member 20, such as signal transmission paths or power supply paths, may be secured, it is possible to provide more functions. As a preferable material for the coupling member 6, for example, conductive paste or solder, or anisotropic conductive adhesive (ACA) may be used.

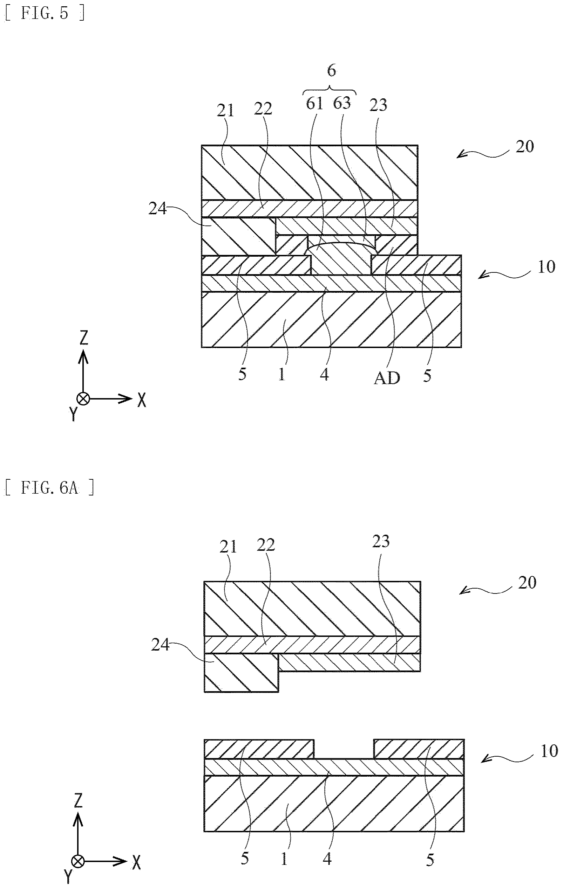

FIG. 5 is an expanded cross-sectional view expansively illustrating an example of detailed configuration of the coupling member 6. The coupling member 6 includes a bump 61, a conductive material layer 63, and an adhesive layer AD. The bump 61 is provided on a surface of the wiring 4 partially, which is exposed without being covered by the resin layer 5. The conductive material layer 63 is sandwiched between the bump 61 and the coupling part 23. As a preferable material for the bump 61 and also as the conductive material layer 63, for example, a conductive paste containing one or more of Ag, Cu, Ni or Sn, and solder, or anisotropic conductive adhesive. Furthermore, likewise the configuration of the conductive material layer 63, the adhesive layer AD may also be made of anisotropic conductive adhesive. In that case, it is possible to form the adhesive layer AD and the conductive material layer 63 simultaneously, by using the same anisotropic conductive adhesive. Note that, the anisotropic conductive layer is an adhesive in which a plurality of conductive particles are dispersed in an insulating adhesive. Thus, for example, with regard to the anisotropic conductive adhesive, which has been pressed and sandwiched between the bump 61 and the coupling part 23, a plurality of conductive particles becomes in a conductive state to each other, and forms the conductive material layer 63. In contrast, the anisotropic conductive adhesive, in a region other than the region sandwiched between the bump 61 and the coupling part 23, forms the adhesive layer AD exhibiting insulating characteristics.

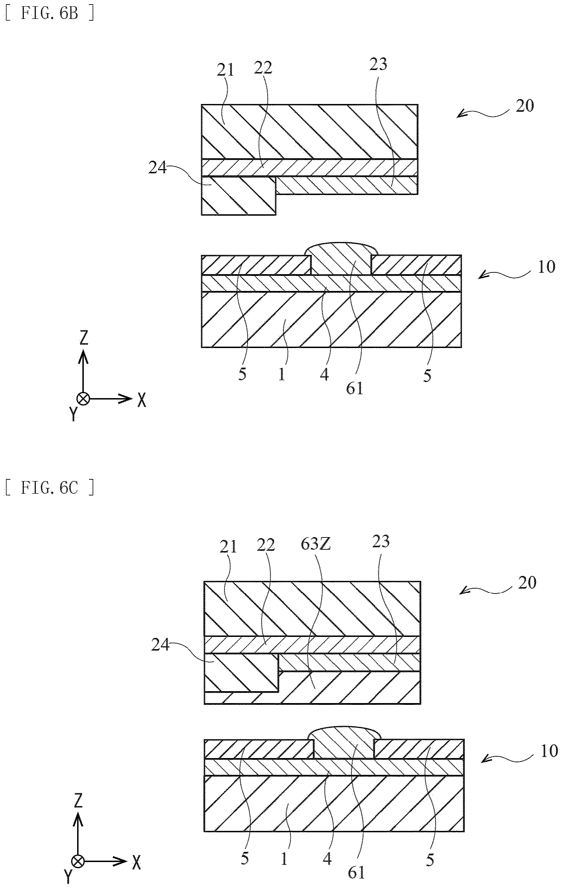

FIG. 6A to FIG. 6C are cross-sectional views illustrating a forming process of the coupling member 6 of the light emitting device 100. First, as illustrated in FIG. 6A, the wiring 4 of the light source unit 10 and the wiring 22 of the relay sheet member 20 are disposed to face each other. Next, as illustrated in FIG. 6B, the bump 61 is formed to cover the wiring 4. Subsequently, as illustrated in FIG. 6C, anisotropic conductive adhesive 63Z is formed to cover the bump 61. Finally, by pressing the anisotropic conductive adhesive 63Z to be sandwiched between the bump 61 and the coupling part 23, the conductive material layer 63 is formed, in which the anisotropic conductive adhesive 63Z, sandwiched between the bump 61 and the coupling part 23, has conductivity. Moreover, the anisotropic conductive adhesive, which was not sandwiched and pressed between the bump 61 and the coupling part 23, forms the adhesive layer AD exhibiting insulating characteristics. As described above, the coupling member 6 is formed, and the light source unit 10 and the relay sheet member 20 are joined to each other. Note that, although the process for forming the bump 61 only on the wiring 4 is exemplified in FIG. 5 to FIG. 6C, the present disclosure is not limited to this process. For example, it is also possible to form the coupling member 6, by providing bumps on both the wiring 4 and the coupling part 23, to sandwich and press the anisotropic conductive adhesive 63Z therebetween.

### (Protection Sheet Member 30)

The protection sheet member 30 is provided for the multiple light source units 10 in common. As described above, the protection sheet member 30 is joined to the back surface 1BS of the light source substrate 1 of each of the multiple light source units 10. As illustrated in FIG. 3, the protection sheet member 30 includes, for example, a base material 31, and an adhesive layer 32. The base material 31 is adhered to the back surface 1BS of the light source substrate 1 by the adhesive layer 32. The base material 31 may be made, for example, of material substantially the same as the material for the base material 21 of the relay sheet member 20. Thus, the base material 31 may be a reflective sheet, serving as a reflective layer that reflects light from the one or more light sources 2 of each of the multiple light source units 10. Moreover, the base material 31 may be a flexible film member. Note that, all of the light source substrate 1, the relay sheet member 20, and the protection sheet member 30, may have flexibility. In that case, handling efficiency will be improved. Moreover, by providing the protection sheet member 30, it is also possible to prevent oxidation of the wiring 22 of the relay sheet member 20, or oxidation of the wiring 4 of each of the light source units 10. Furthermore, by providing the protection sheet member 30, it is possible to reinforce mechanical strength of the light emitting device 100.

### [1.2 Functions]

As illustrated in FIG. 3, with regard to the light emitting device 100 of the present embodiment, a part of the blue light LB, which has been emitted from the semiconductor layer 73 of the light source 2, is converted into the light LY, that is light of which wavelength is converted by (which is emitted from) the wavelength conversion member. The wavelength-converted light LY is, for example, red light and green light, or yellow light. In regard to the blue light LB emitted from the semiconductor layer 73, the blue light LB, which has not been absorbed in the wavelength conversion member 81, is also emitted from the light source 2. A part of the blue light LB, for which the wavelength conversion has not been made and which is progressing in a forward direction, and a part of the light LY, for which the wavelength conversion has been made and which is proceeding in the forward direction, are synthesized to generate white light, and emitted in the forward direction (to the outside of the light source unit).

As described above, the light emitting device 100 according to the present embodiment includes the one relay sheet member 20, which supports each of the multiple light source units 10, and which is electrically coupled to each of the multiple light source units 10. Thus, according to the light emitting device 100, because both the electrical connection and the mechanical connection between the multiple light source units 10 are performed via the one relay sheet member 20 containing the wiring 22, it is possible to facilitate overall reduction in weight and thickness of the light emitting device 100. Moreover, according to the light emitting device 100, because both the electrical connection and the mechanical connection between the multiple light source units 10 are performed via the one relay sheet member 20 containing the wiring 22, it is possible to finely adjust position arrangement of each of the multiple light source units 10 easily, and optimization of position arrangement of each of the light sources 2 may be accomplished easily. Thus, because the multiple light source units 10 are coupled to each other by the one relay sheet member 20, as compared with a configuration in which a plurality of light sources is disposed on one board-shaped substrate, for example, it is possible to reduce the amount of material used for the light source substrate 1, while including the plurality of light sources 2. Specifically, the total area of the plurality of light source substrates 1, each of which is provided with one or more light sources 2, may be made approximately to be 0.25 or less of the area of the light emitting surface of the light emitting device 100. Moreover, according to the light emitting device 100 of the present embodiment, the relay sheet member 20 is used as the reflective sheet. Thus, the total area of the plurality of light source substrates 1, each of which is provided with wone or more light sources 2, may be made approximately to be half or less of the area of the reflective sheet. The light source substrate 1, on which the light source 2 is mounted, is required to be in high quality, to enable, for example, forming of high-definition thin film pattern. Consequently, the cost becomes generally expensive. Therefore, according to the light emitting device 100, because the total area of the light source substrate 1 may be reduced, it is possible to realize high-definition luminance distribution, while reducing the weight, thickness and cost.

Moreover, according to the light emitting device 100 of the present embodiment, as compared with the size of the plurality of wirings 4 formed on each of the light source substrates 1 and also with the disposition preciseness of each of the wirings 4, it is possible to relatively enlarge the size of the wiring 22, coupling each of the light source substrates 1 of each of the multiple light source units 10, and furthermore, it is also possible to lower the disposition preciseness of the wiring 22. This is because the light emitting device 100 is configured to be produced, by separately manufacturing the multiple light source units 10 in which each of the light source substrates 1 is provided with the light source 2 and the wiring 4, and the one relay sheet member 20 on which the wiring 22 is provided, and thereafter, by coupling the multiple light source units 10 to each other by using the one relay sheet member 20. Accordingly, it is possible to improve manufacturing facility of the light emitting device 100 in total, and improvement in yield in the manufacturing process may be expected.

According to the light emitting device 100 of the present embodiment, the relay sheet member 20 is joined to the front surface 1FS, that is the light emitting surface side of each of the light source substrates 1 of the multiple light source units 10, and the relay sheet member 20 includes the base material 21 serving as the reflective layer that reflects light from each of the light sources 2. Therefore, it is possible to improve light emission efficiency of the light emitting device 100.

According to the light emitting device 100 of the present embodiment, the protection sheet member 30 is joined to the back surface 1BS of each of the light source substrates 1 of the multiple light source units 10. Because the protection sheet member 30 is provided, it is possible to prevent oxidation or corrosion of the wiring 22 of the relay sheet member 20, and it is also possible to prevent oxidation or corrosion of each of the plurality of wirings 4 of the multiple light source units 10. Furthermore, because the protection sheet member 30 is provided, it is possible to reinforce mechanical strength of the light emitting device 100.

Moreover, according to the light emitting device 100, the multiple light source units 10 and the relay sheet member 20 are joined to each other via the conductive coupling members 6. Thus, for example, as compared with the bonding via connectors, it is possible to simplify, and to reduce in size, thickness and weight of each of coupling parts between the multiple light source units 10 and the relay sheet member 20. Accordingly, as compared with the case of using connectors, it is possible to reduce in size of each of the light source units 10, and the number of light sources 2 per unit region may be increased. Thus, it is possible to realize the plurality of light sources 2 to be highly integrated. Moreover, as compared with the case of using connectors, it is also possible to improve manufacturing facility. The light emitting device 100 may be configured to bond each of the multiple light source units 10 to the relay sheet member 20 by the coupling member 6 at each of the multiple points. Because the multiple light source units 10 and the relay sheet member 20 are coupled to each other at the multiple points, the multiple light source units 10 may be held to the relay sheet member 20 more stably. Moreover, because the plurality of channels between each of the light source units 10 and the relay sheet member 20, such as signal transmission paths or power supply paths, may be secured, the light emitting device 100 may be provided with more functions.

Moreover, according to the light emitting device 100, because the relay sheet member 20 and the protection sheet member 30 are flexible, it is possible to use suitably, for example, for a display device having a curved screen.

Moreover, according to the light emitting device 100, the multiple light source units 10 are fixed and integrated by the one relay sheet member 20. Thus, handling of semi-finished products in the course of manufacturing process may be facilitated, and for example, working to bond the multiple light source units 10 to the relay sheet member 20 may be performed collectively, and consequently, manufacturing facility improves.

Moreover, according to the light emitting device 100, the relay sheet member 20 includes the apertures 21K in the regions, each of which is overlapping with the light source 2 in the Z-axis direction. Thus, even in a case where the relay sheet member 20 is disposed on the light emitting side of the light source 2, bonding to the multiple light source units 10 may be performed by avoiding a region in which the light source 2 exists. Therefore, it is possible to avoid obstruction to progress of the emitted light by the relay sheet member 20.

Moreover, according to the light emitting device 100, the driver that drives the plurality of light sources 2 is provided at least on one of the relay sheet member 20 or the light source substrate 1. Thus, as compared with a case where the driver 40 is provided on the outside of the light emitting device 100, it is possible to drive the plurality of light sources 2 at a faster speed.

### [1.3 Effects]

As described above, according to the light emitting device 100 of the present embodiment, it is possible to exhibit excellent light emission performance, while achieving high integration by arranging the plurality of light sources at a higher density. Moreover, it is also possible to improve manufacturing facility, and to realize reduction in thickness and weight in total.

### [1.4 Modification Examples of the First Embodiment]

### (Modification Example 1-1)

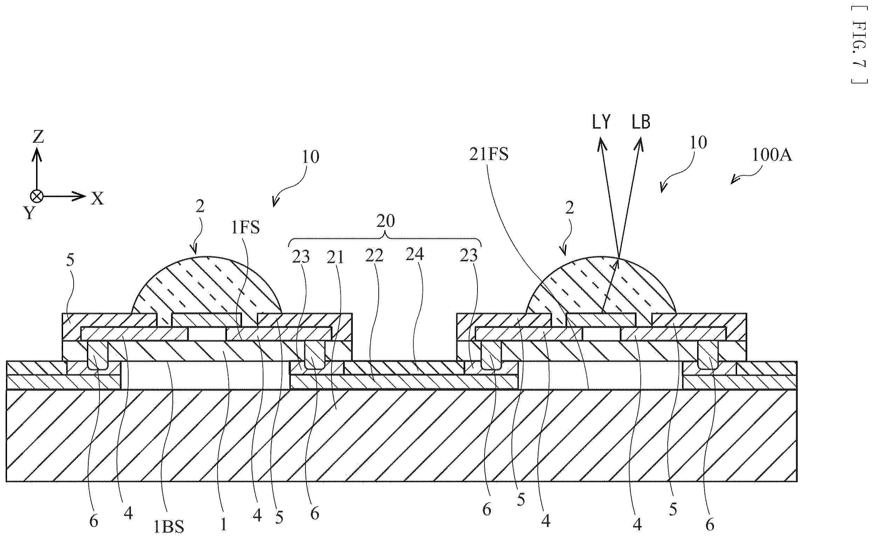

FIG. 7 is a cross-sectional view illustrating an example of configuration of a light emitting device 100A according to a first modification example (modification example 1-1) of the first embodiment. According to light emitting device 100A, the relay sheet member 20 is arranged in a manner that the front surface 21FS faces the back surface 1BS of one of the light source substrate 1 of each of the light source units 10. According to the light emitting device 100A, the wiring 22 is selectively provided on a part of the front surface 21FS of the base material 21 facing the back surface 1BS of each of the light source substrates 1. The insulation film 24 is provided to cover the wiring 22. The insulation film 24 may be preferably made of material having a high reflectance, for example, for the light LB from the light source 2, and for the light LY, of which wavelength has been converted by the wavelength conversion member 81. The insulation film 24 may also contain, as material having a high reflectance, titanium dioxide or Ag (silver). Specifically, the insulation film 24 is, for example, a white resist layer. As an example of white resist, inorganic materials such as titanium dioxide (TiO₂) fine particles or barium sulfate (BaSO₄) fine particles, or porous acrylic resin fine particles having countless pores for light scattering, or organic materials such as polycarbonate resin fine particles, may be used. As material for the insulation film 24, epoxy resin may also be used. Furthermore, the insulation film 24 may be made of resin containing inorganic fine particles, such as titanium dioxide (TiO₂) fine particles or barium sulfate (BaSO₄) fine particles.

Thus, according to the light emitting device 100A, the relay sheet member 20 is provided to face the back surface 1BS of the light source substrate 1 of each of the multiple light source units 10. Thus, according to the light emitting device 100A, it is not necessary to provide the apertures 21K in the base material 21, it is possible to secure mechanical strength without providing the protection sheet member 30.

### (Modification Example 1-2)

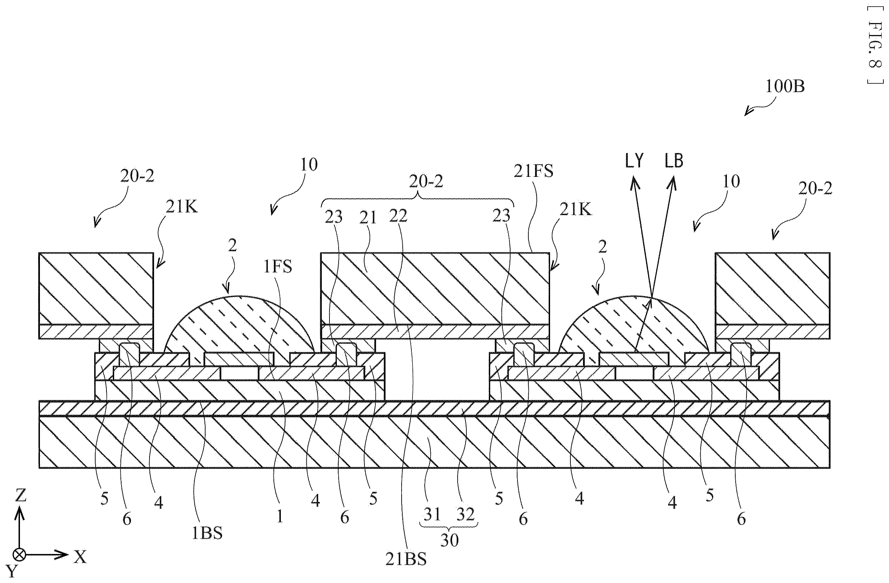

FIG. 8 is a cross-sectional view illustrating an example of configuration of a light emitting device 100B according to a second modification example (modification example 1-2) of the first embodiment. According to the light emitting device 100B, a relay sheet member 20-2 is adopted instead of the relay sheet member 20. The relay sheet member 20-2 does not include the insulation film 24 for covering the wiring 22. Except for this feature, the configuration of the light emitting device 100B is the same as the configuration of the light emitting device 100 described above.

### (Modification Example 1-3)

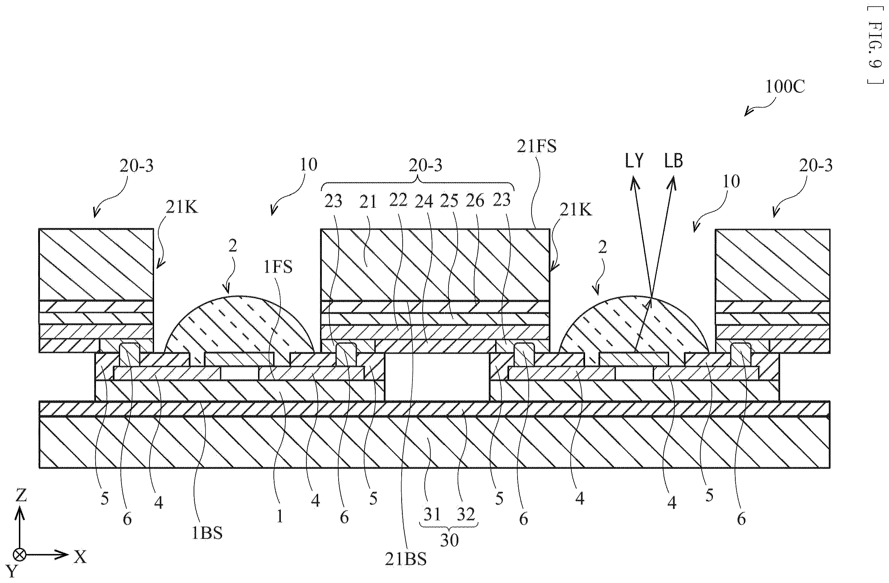

FIG. 9 is a cross-sectional view illustrating an example of configuration of a light emitting device 100C according to a third modification example (modification example 1-3) of the first embodiment. According to the light emitting device 100C, a relay sheet member 20-3 is adopted instead of the relay sheet member 20. The relay sheet member 20-3 includes an insulation film 25 and an adhesive layer 26, from the side of the wiring 22 in that order, between the base material 21 and the wiring 22. Except for this feature, the configuration of the light emitting device 100C is the same as the configuration of the light emitting device 100 described above.

According to the light emitting device 100C, because of the above configuration, for example, instead of providing the wiring 22 directly on the back surface 21BS of the base material 21, the relay sheet member 20-3 may be prepared according to a method described below. Specifically, a flexible printed substrate, in which the wiring 22 has been patterned on the insulation film 25, is prepared in advance. Then, the flexible printed substrate is joined to the back surface 21BS of the base material 21 by the adhesive layer 26, and accordingly, the relay sheet member 20-3 is prepared. Because the relay sheet member 20-3 is produced by this method, when the wiring 22 is patterned, it is possible to prevent heat from being applied to the base material 21.

Therefore, because of configuration of the relay sheet member 20-3 described above, it is even possible to adopt, for example, material liable to be degraded by heat, for the base material 21.

### (Modification Example 1-4)

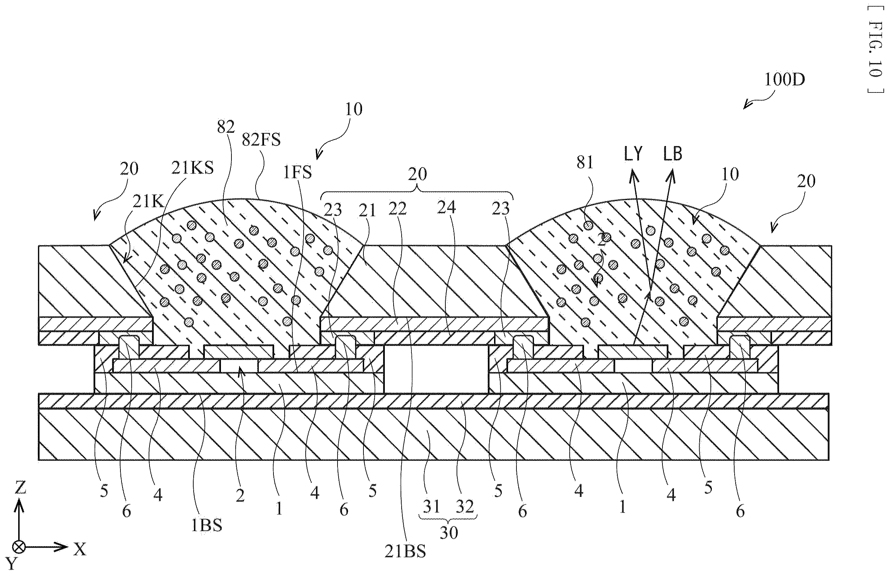

FIG. 10 is a cross-sectional view illustrating an example of configuration of a light emitting device 100D according to a fourth modification example (modification example 1-4) of the first embodiment. According to the light emitting device 100D, a sealing resin 82 is provided instead of the sealing lens 72. The sealing resin 82 is filled, for example, in the aperture 21K. Except for this feature, the configuration of the light emitting device 100D is substantially the same as the configuration of the light emitting device 100 described above. The sealing resin 82 may also contain lens functions by including a curved front surface 82FS. Moreover, the wavelength conversion member 81 may be embedded in the sealing resin 82. Furthermore, light diffusion particles may be embedded in the sealing resin 82. As illustrated in FIG. 10, an edge surface 21KS of the aperture 21K may preferably be inclined, in a form that, an inner diameter of the aperture 21K becomes wider, as the distance from the semiconductor layer 73 becomes longer in the Z-axis direction.

According to the light emitting device 100D, because of larger volume than the sealing lens 72, it is possible to acquire sufficient optical effects, such as wavelength conversion or light scattering, without separately providing a wavelength conversion sheet or a diffusion sheet in front of the multiple light source units 10.

### (Modification Example 1-5)

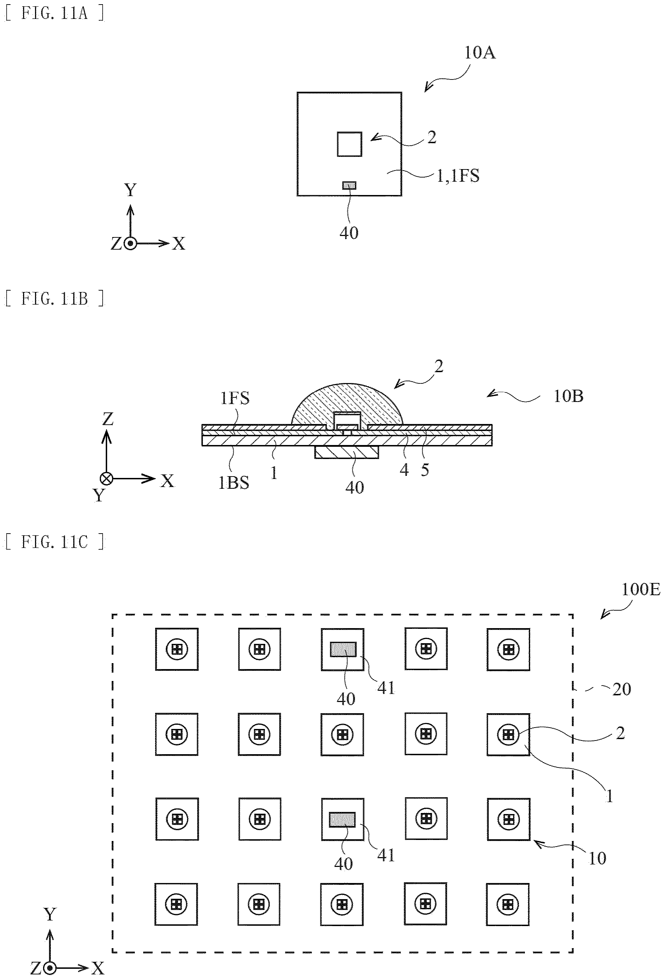

FIG. 11A is a schematic plan view illustrating an example of configuration of a light source unit 10A according to a fifth modification example (modification example 1-5) of the first embodiment. According to the light source unit 10A, the driver 40 is provided, on the front surface 1FS of the light source substrate 1 provided with the light source 2. The light source 2 is driven by the driver 40.

### (Modification Example 1-6)

FIG. 11B is a schematic cross-sectional view illustrating an example of configuration of a light source unit 10B according to a sixth modification example (modification example 1-6) of the first embodiment. According to the light source unit 10B, the driver 40 is provided on the back surface 1BS, which is the side opposite to the front surface 1FS of the light source substrate 1 provided with the light source 2. The light source 2 is driven by the driver 40.

### (Modification Example 1-7)

FIG. 11C is a schematic plan view illustrating an example of configuration of a light emitting device 100E according to a seventh modification example (modification example 1-7) of the first embodiment. According to the light emitting device 100E, among the multiple light source units 10 discretely aligned in both the X-axis and Y-axis directions, some of the light source units 10 have been replaced by the drivers 40. The driver 40 is mounted on a substrate 41 made of, for example, the same material as that of the light source substrate 1. Likewise, the configuration of the light source substrate 1, the substrate 41 is joined to the relay sheet member 20. The driver 40 is configured to drive the light sources of the several light source units 10, provided in the surrounding region.

### (Modification Example 1-8)

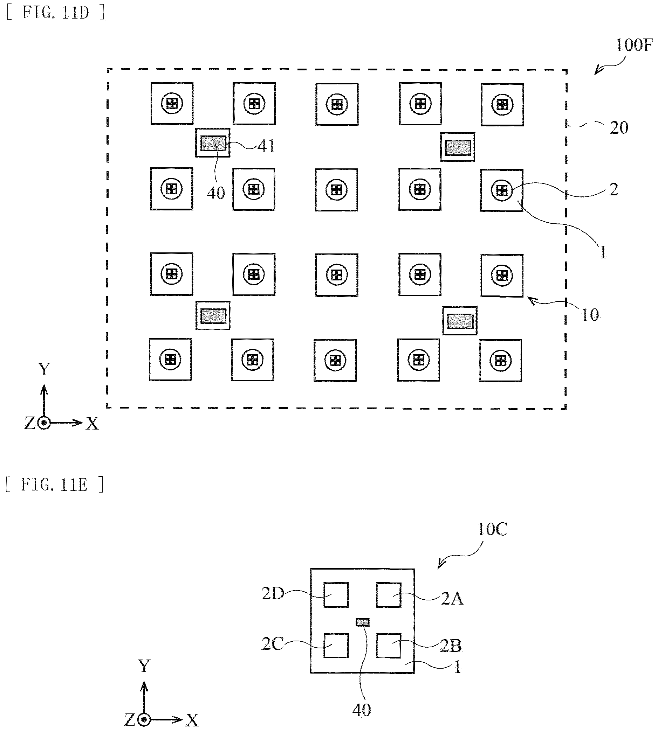

FIG. 11D is a schematic plan view illustrating an example of configuration of a light emitting device 100F according to an eighth modification example (modification example 1-8) of the first embodiment. According to the light emitting device 100F, several drivers 40 are placed in gaps between the multiple light source units 10 adjacent to each other, discretely aligned in both the X-axis and Y-axis directions. The driver 40 is mounted on a substrate 41 made of, for example, the same material as that of the light source substrate 1. Likewise, the configuration of the light source substrate 1, the substrate 41 is joined to the relay sheet member 20. The driver 40 is configured to drive the light sources of the several light source units 10, provided in the surrounding region.

### (Modification Example 1-9)

FIG. 11E is a schematic plan view illustrating an example of configuration of a light source unit 10C according to a ninth modification example (modification example 1-9) of the first embodiment. The light source unit 10C includes a plurality of light sources 2 (2A to 2D) provided on the front surface 1FS of the one light source substrate 1, and the driver 40 provided in a gap between the plurality of light sources 2 on the front surface 1FS. Each of the plurality of light sources 2 (2A to 2D) is driven by the driver 40. Here, each of the light sources 2A to 2D may contain the light emitting element that emits the same color (for example, all blue LEDs). Alternatively, among the light sources 2A to 2D, at least some of them may contain the light emitting elements that emit another color than the color of the other elements. More specifically, for example, the light source 2A may contain a blue LED that emits blue light, the light source 2B and light source 2D may contain green LEDs that emit green light, and the light source 2C may contain a red LED that emits red light. Alternatively, for example, the light source 2A may emit blue light, the light source 2B may emit green light, the light source 2C may emit red light, and the light source 2D may emit yellow light or white light.

### (Modification Example 1-10)

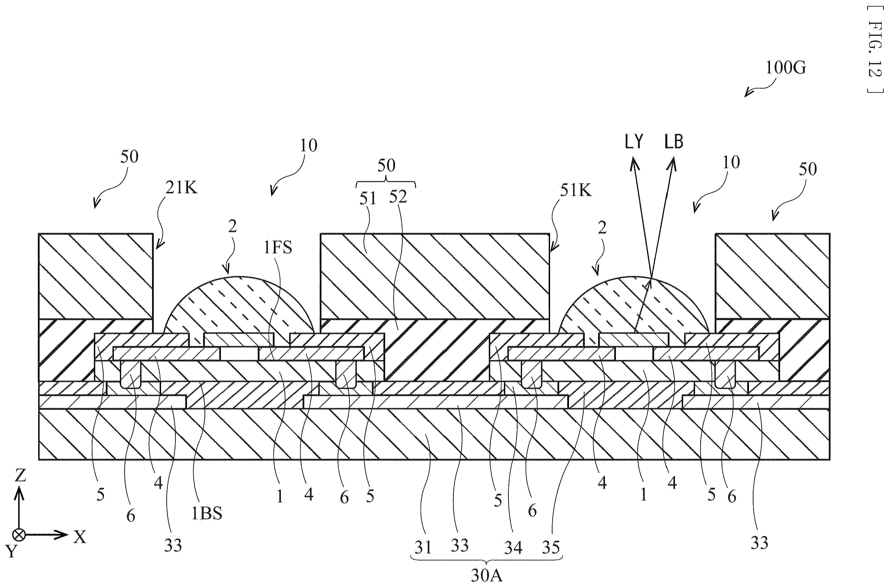

FIG. 12 is a schematic cross-sectional view illustrating an example of configuration of a light emitting device 100G according to a tenth modification example (modification example 1-10) of the first embodiment. The light emitting device 100G is provided with a reflective sheet member 50 instead of the relay sheet member 20, and also provided with a protection sheet member 30A instead of the protection sheet member 30. According to the light emitting device 100G, a wiring 33 and a coupling part 34 are provided on the protection sheet member 30A, and the protection sheet member 30A may also be used as a relay sheet member .

The protection sheet member 30A includes the base material 31, the wiring 33, the coupling part 34, and an insulation film 35. According to the protection sheet member 30A, the wiring 33 is selectively provided on an upper surface of the base material 31 facing the light source substrate 1. The coupling part 34 is a conductive pad, and is provided, as viewed from the wiring 33, on a side opposite to the base material 31, to cover a part of the wiring 33. The insulation film 35 may preferably be provided to cover a part of the wiring 33, that is the part other than that covered by the coupling part 34. This is because, by serving as a protective film for the wiring 33 to reduce opportunity to be in contact with outer air or moisture, it is possible to prevent deterioration in the wiring 33, such as oxidation or degrading.

According to the light emitting device 100G, the wiring 4, which has been provided on the light source substrate 1, is electrically coupled to the coupling part 34 via the coupling member 6.

The reflective sheet member 50 includes a base material 51 and an adhesive layer 52. The base material 51 is adhered to the light source substrate 1 and the protection sheet member 30A by the adhesive layer 52. The base material 51 may be made, for example, of material substantially the same as the material for the base material 21 of the relay sheet member 20. Thus, the base material 51 is, for example, a white resist layer. The base material 51 has a high reflectance, for example, for the light LB from the light source 2, and the light LY, of which wavelength has been converted by the wavelength conversion member 81. The base material 51 is provided with an aperture 51K at a position overlapping with the light source 2 in the Z-axis direction.

### <2. Second Embodiment>

### [2.1 Configuration]

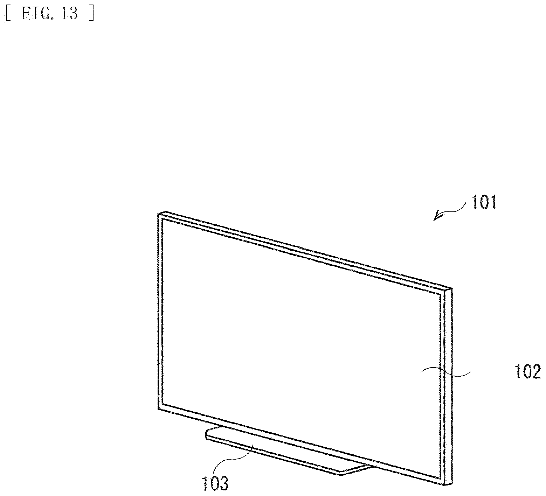

FIG. 13 illustrates an appearance of a display device 101 according to a second embodiment of the present technology. The display device 101 is provided with the light emitting device 100, and is used, for example, as a flat-screen television set, and has a configuration that a flat-panel-shaped main body 102 for displaying image is supported by a stand 103. Note that, the display device 101 is used as a stationary type placed on a horizontal surface such as a floor, shelf, or stand, in a state that the stand 103 is attached to the main body 102, but it is also possible to use as a wall-mounted type, in a state that the stand 103 is detached from the main body 102.

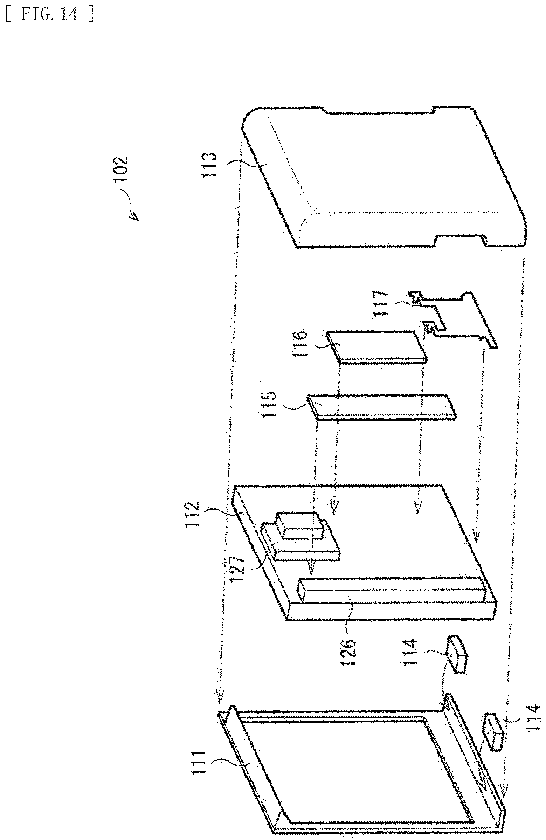

FIG. 14 illustrates a disassembled state of the main body 102 shown in FIG. 13. The main body 102 includes, for example, a front outer casing member (bezel) 111, a panel module 112, and a rear outer casing member (rear cover) 113, in that order as viewed from a front side (a viewer's side). The front outer casing member 111 is a member in a shape of picture frame for covering a front periphery of the panel module 112, and a pair of speakers 114 is positioned underneath. The panel module 112 is fixed to the front outer casing member 111, and a power supply substrate 115 and a signal substrate 116 are mounted on, and a mounting fitting 117 is fixed to, a rear surface of the panel module 112. The mounting fitting 117 is used for attaching a wall-mounting bracket, a substrate, etc., and also for attaching the stand 103. The rear outer casing member 113 covers a rear surface and side surfaces of the panel module 112.

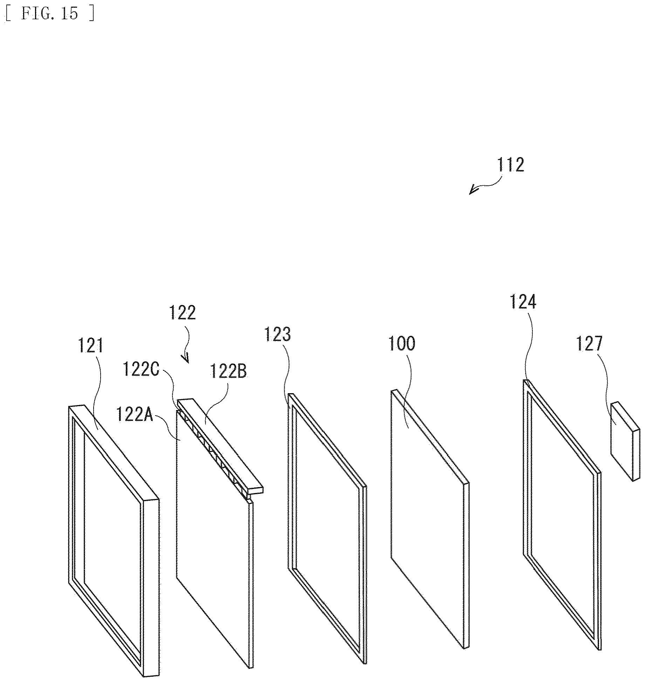

FIG. 15 illustrates a disassembled state of the panel module 112 shown in FIG. 14. The panel module 112 includes, for example, a front housing (top chassis) 121, a liquid crystal panel 122, a frame-shaped member (middle chassis) 123, the light emitting device 100, a rear housing (back chassis) 124, and a timing controller substrate 127, in that order from the front side (the viewer's side).

The front housing 121 is a frame-shaped metal component for covering a front periphery of the liquid crystal panel 122. The liquid crystal panel 122 includes, for example, a liquid crystal cell 122A, a source substrate 122B, and a flexible substrate 122C for their connection, such as COF (chip on film). The frame-shaped member 123 is a frame-shaped resin component for holding the liquid crystal panel 122. The rear housing 124 is a metal component made of iron (Fe), etc., for accommodating the frame-shaped member 123 and the light emitting device 100. Furthermore, the timing controller substrate 127 is also mounted on a rear surface of the rear housing 124.

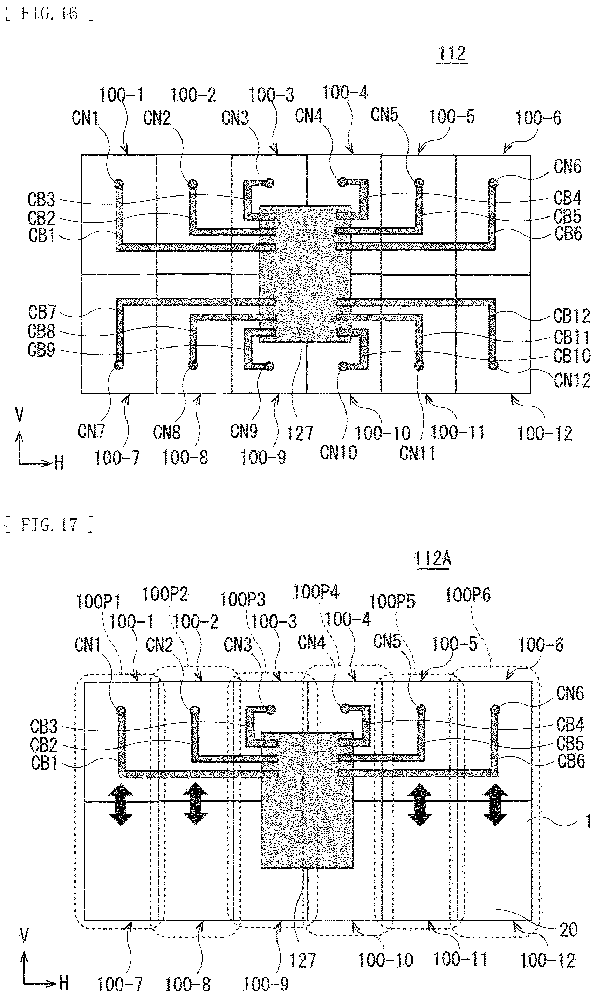

FIG. 16 is a schematic plan view illustrating a configuration example of the panel module 112 more specifically. According to the example of the panel module 112 as illustrated in FIG. 16, in total twelve light emitting devices 100 (100-1 to 100-12) are arranged, in a region corresponding to a display region of the liquid crystal panel 122, extending in an H-direction (horizontal direction) and a V-direction (vertical direction). Specifically, six rows of light emitting devices 100 are aligned in the H-direction, and two columns of light emitting devices 100 are aligned in the V-direction. As illustrated in FIG. 16, according to the panel module 112, the timing controller substrate 127 is provided, for example, in a central region of the panel module 112. The timing controller substrate 127 and each of the plurality of light emitting devices 100 (100-1 to 100-12) is coupled respectively, for example, by cables CB (CB1 to CB12) and connectors CN (CN1 to CN12). Alternatively, the timing controller substrate 127 and the plurality of light emitting devices 100 (100-1 to 100-12) may be coupled by using anisotropic conductive adhesive (ACP, ACF).

### [2.2 Functions and Effects]

According to the display device 101, light from the light emitting devices 100 is selectively transmitted through the liquid crystal panel 122, to perform the image display. Here, as explained in the first embodiment, because the light emitting devices 100, having excellent light emission controllability and improved light emission efficiency, are provided, improvement in display quality of the display device 101 may be expected.

### [2.3 Modification Examples of the Second Embodiment]

### (Modification Example 2-1)

FIG. 17 is a schematic plan view illustrating a panel module 112A as a first modification example (modification example 2-1) of the second embodiment. According to the panel module 112 as illustrated in FIG. 16, the timing controller substrate 127 and all of the light emitting devices 100 are individually and directly coupled by the cables CB and the connectors CN. In contrast, according to the panel module 112A, for example, the relay sheet members 20 of two light emitting devices 100 adjacent to each other in the V-direction are electrically coupled, to form six light emitting device pairs 100P (100P1 to 100P6). Specifically, each of the light emitting devices 100-1 to 100-6 and each of the corresponding light emitting devices 100-7 to 100-12 is coupled to each other, to form the light emitting device pairs 100P1 to 100P6. Connection of the relay sheet members 20 to each other, may be performed, for example, by using a board-to-board connector, or by using a flexible printed circuit board (FPC) with anisotropic conductive adhesive (ACA). The timing controller substrate 127 and each of six light emitting device pairs 100P1 to 100P6 is coupled respectively, by the cables CB1 to CB6 and the connectors CN1 to CN6. Alternatively, the timing controller substrate 127 and six light emitting device pairs 100P1 to 100P6 may be coupled by using anisotropic conductive adhesive (ACP, ACF).

According to the panel module 112A of FIG. 17, as compared with the panel module 112 (FIG. 16) of the second embodiment described above, in a case where the same number of light emitting devices 100 is used, it is possible to reduce the number of cables CB and the connectors CN, or the number of bonding points by anisotropic conductive adhesive.

### (Modification Example 2-2)

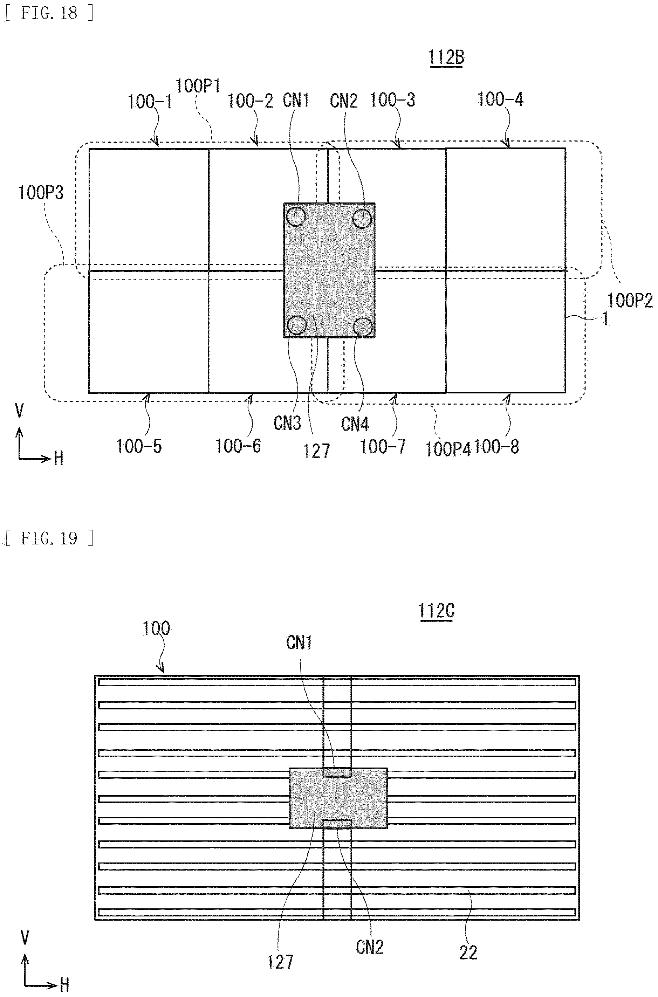

FIG. 18 is a schematic plan view illustrating a panel module 112B as a second modification example (modification example 2-2) of the second embodiment. The panel module 112B of the present modification example includes in total eight light emitting devices (100-1 to 100-8), aligned in four rows in the H-direction and aligned in two columns in the V-direction. According to the panel module 112B, it is also possible to form, for example, in total four light emitting device pairs 100P1 to 100P4, by coupling the relay sheet members 20 of two light emitting devices 100 adjacent to each other in the H-direction. Specifically, the light emitting device pair 100P1 may be formed by coupling the relay sheet members 20 of the light emitting devices 100-1 and 100-2 to each other, the light emitting device pair 100P2 may be formed by coupling the relay sheet members 20 of the light emitting devices 100-3 and 100-4 to each other, the light emitting device pair 100P3 may be formed by coupling the relay sheet members 20 of the light emitting devices 100-5 and 100-6 to each other, and the light emitting device pair 100P4 may be formed by coupling the relay sheet members 20 of the light emitting devices 100-7 and 100-8 to each other. The connection between the relay sheet members 20 to each other is performed as described above. According to the panel module 112B, the timing controller substrate 127 and the light emitting device pairs 100P1 to 100P4 are coupled to each other by the connectors CN1 to CN4. Alternatively, the timing controller substrate 127 and the light emitting device pairs 100P1 to 100P4 may be coupled by using anisotropic conductive adhesive (ACP, ACF). Note that, according to the panel module 112B, for example, the relay sheet members 20 of four light emitting devices 100-1 to 100-4, aligned in the H-direction, may be electrically coupled to each other, and besides, the relay sheet members 20 of four light emitting devices 100-5 to 100-8 may be electrically coupled to each other. Moreover, according to the panel module 112B, the timing controller substrate 127 and all of the light emitting devices 100-1 to 100-8 may be individually and directly coupled to each other, by using at least one, that is, by the cables CB and the connectors CN, or by anisotropic conductive adhesive (ACP, ACF).

### (Modification Example 2-3)

FIG. 19 is a schematic plan view illustrating a panel module 112C as a third modification example (modification example 2-3) of the second embodiment. The panel module 112B (FIG. 17) of the modification example 2-2 described above is formed by the plurality of light emitting devices 100 coupled to each other. In contrast, the panel module 112C of the present modification example is formed by the one light emitting device 100. According to the panel module 112C, the timing controller substrate 127 and the wiring 22, provided on the rear surface of the light emitting device 100, may be coupled by using at least one, that is, by cables and connectors, or by anisotropic conductive adhesive (ACP, ACF).

### <3. Other Modification Examples>

Although the present disclosure has been described with reference to the embodiments and modification examples, the present disclosure is not limited to the above-described embodiments and the like, and various modifications are possible. For example, material, type, arrangement position, and shape of each of the structural elements of the light emitting device, explained with reference to the above embodiments, are not limited to the above explanation.

### [3.1 Modification Example 3-1]

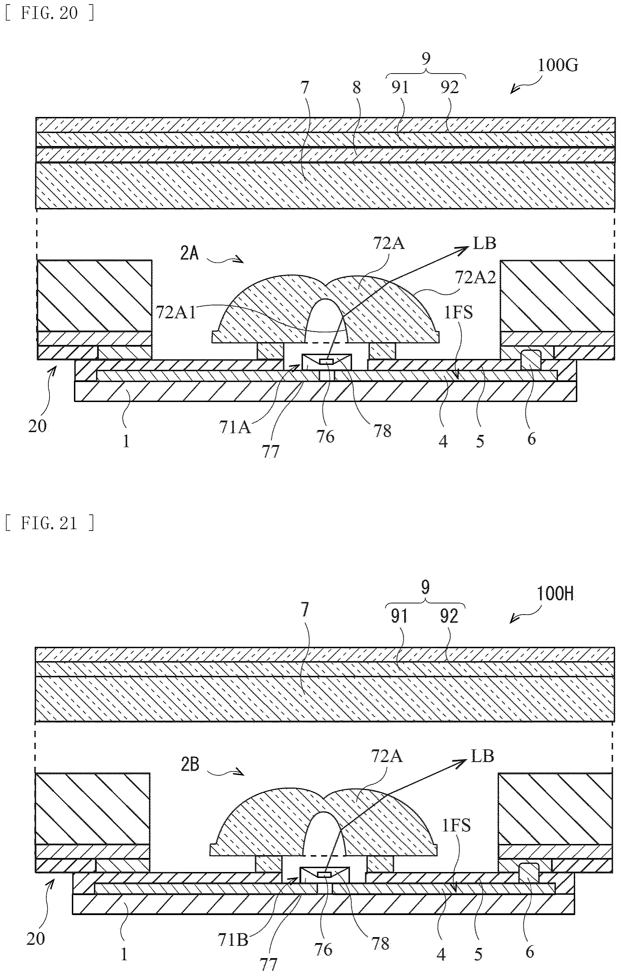

FIG. 20 is an expanded cross-sectional view illustrating a part of a light emitting device 100G as a modification example 3-1 of the present disclosure. According to the first embodiment, the light emitting element 71 is sealed by the sealing lens 72, but the present disclosure is not limited to this embodiment. The light emitting device 100G is provided with a light source 2A instead of the light source 2. The light source 2A includes a light emitting element 71A instead of the light emitting element 71, and also includes a cap lens 72A instead of the sealing lens 72.

The light emitting element 71A is, for example, a packaged blue LED. Specifically, the light emitting element 71A includes a light emitting layer 76, a base 77, and a sealing material 78. The base 77 includes an accommodation part in a concave shape. The light emitting layer 76 is positioned on a bottom surface of the accommodating part of the base 77. The sealing material 78 is filled in the accommodating part of the base 77. The light emitting layer 76 is, for example, a point light source, and specifically, is formed by a blue LED. The base 77 is mounted on the light source substrate 1 by soldering, etc., via external electrodes, such as lead frames. It is preferable that the surface of the accommodating part of the base 77 has a high reflectance for light from the light emitting layer 76. The surface of the accommodation part of the base 77 may contain, for example silver (Ag), as material having a high reflectance. The sealing material 78 is made of transparent resin, such as silicone or acrylic. The cap lens 72A is positioned directly above the light emitting element 71A, separated from the light emitting element 71A. A light entering surface 72A1 is provided at a center of the cap lens 72A, opposing to the light emitting element 71A in the Z-axis direction, in a concave shape aiming at the light emitting element 71A. Moreover, the cap lens 72A includes a light emitting surface 72A2, for example in a convex shape, aiming at a diffusion sheet 7 provided on a side opposite to the light emitting element 71A. Both the light entering surface 72A1 and the light emitting surface 72A2 exhibit diffusion effects for the blue light LB from the light emitting element 71A.

Moreover, the light emitting device 100G may further include the diffusion sheet 7, a wavelength conversion sheet 8, and an optical sheet group 9.

The diffusion sheet 7 is an optical member disposed between the wavelength conversion sheet 8 and the plurality of light sources 2A. The diffusion sheet 7 uniformizes angular distribution of entered light. The diffusion sheet 7 may be one diffusion panel or one diffusion sheet, or may be two or more diffusion panels, or two or more diffusion sheets. Moreover, the diffusion sheet 7 may be a panel-shaped optical member having a certain thickness and a certain hardness.

The wavelength conversion sheet 8 is disposed to be opposed to the plurality of light sources 2A. The wavelength conversion sheet 8 includes, for example, the wavelength conversion member 81 in the form of particles.

The optical sheet group 9 is an optical member disposed on a side of a light emitting surface of the wavelength conversion sheet 8, that is the side opposite to the diffusion sheet 7 as viewed from the wavelength conversion sheet 8. The optical sheet group 9 is formed by containing, for example sheets or films for improving luminance. In the example as illustrated in FIG. 18, the optical sheet group 9 is formed by stacking an optical sheet 91 and an optical sheet 92, in that order on the wavelength conversion sheet 8. The optical sheet 91 and the optical sheet 92 may also be joined to each other to be integrated. The optical sheet 91 is, for example, a prism sheet. The optical sheet 92 is, for example, a reflective polarizing film such as DBEF (dual brightness enhancement film). Note that, the number of optical sheets forming the optical sheet group 9, and type and stacking order of the plurality of optical sheets forming the optical sheet group 9, may be selected arbitrarily.

According to the light emitting device 100G having the configuration described above, the blue light, which has been emitted from the light emitting element 71A, is diffused by the cap lens 72A and the diffusion sheet 7, and thereafter, during passing through the wavelength conversion sheet 8, the blue light is converted into the white light. Furthermore, the white light, which has been converted from the blue light, is improved in luminance and uniformized by the optical sheet group 9, and is emitted to a liquid crystal panel, etc.

### [3.2 Modification Example 3-2]

According to the light emitting device 100G as the modification example 3-1 described above, the packaged blue LED is used as the light emitting element 71A, but the present disclosure is not limited to this configuration. For example, according to a light emitting element 71B of a light emitting device 100H, illustrated in FIG. 21 as a modification example 3-2 of the present disclosure, a packaged white LED may be adopted instead of the packaged blue LED. The light emitting element 1B includes, the light emitting layer 76 configured by, for example, a blue LED, the base 77, and a sealing material 79 made by transparent resin containing wavelength conversion members. Note that, according to the light emitting device 100H, the wavelength conversion sheet 8 is not required. Thus, as compared with the light emitting device 100G of FIG. 18, it is advantageous to reduce the total thickness.

### [3.3 Modification Example 3-3]

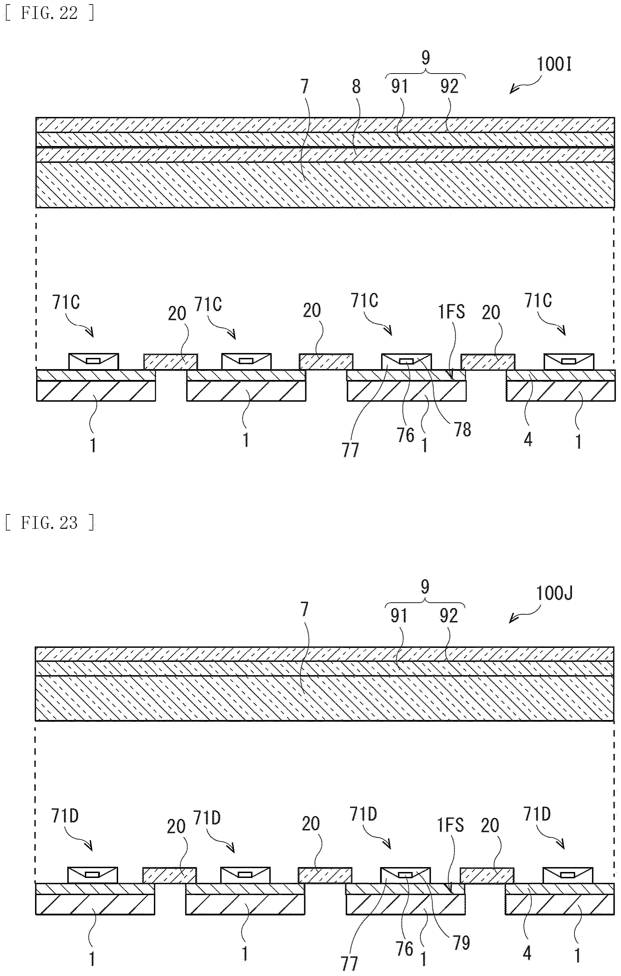

Moreover, the light emitting device of the present disclosure is not limited to a configuration in which the lens is disposed on the side of the light emitting element. For example, according to a light emitting device 1001, illustrated in FIG. 22 as a modification example 3-3 of the present disclosure, a plurality of light emitting elements 71C, each of which is, for example, a packaged blue LED, may be disposed without providing various types of lenses. The light emitting element 71C has substantially the same configuration as the configuration of the light emitting element 71A as illustrated in FIG. 18, and includes, the light emitting layer 76 configured by, for example, a blue LED, the base 77, and the sealing material 78. According to the light emitting device 100I having the configuration described above, the blue light, which has been emitted from the light emitting elements 71C, is diffused by the diffusion sheet 7, and thereafter, during passing through the wavelength conversion sheet 8, the blue light is converted into the white light. Furthermore, the white light, which has been converted from the blue light, is improved in luminance and uniformized by the optical sheet group 9, and is emitted to a liquid crystal panel, etc.

### [3.4 Modification Example 3-4]

According to the light emitting device 100I as the modification example 3-3 described above, the packaged blue LED is used as the light emitting element 71C, but the present disclosure is not limited to this configuration. For example, according to a light emitting element 71D of a light emitting device 100J, illustrated in FIG. 23 as a modification example 3-4 of the present disclosure, a packaged white LED may be adopted instead of the packaged blue LED. The light emitting element 71D has substantially the same configuration as the configuration of the light emitting element 71B as illustrated in FIG. 17, and includes, the light emitting layer 76 configured by, for example, a blue LED, the base 77, and the sealing material 79 made by transparent resin containing wavelength conversion members. According to the light emitting device 100J, the wavelength conversion sheet 8 is not required. Thus, as compared with the light emitting device 100I of FIG. 20, it is advantageous to reduce the total thickness.

### [3.5 Modification Example 3-5]

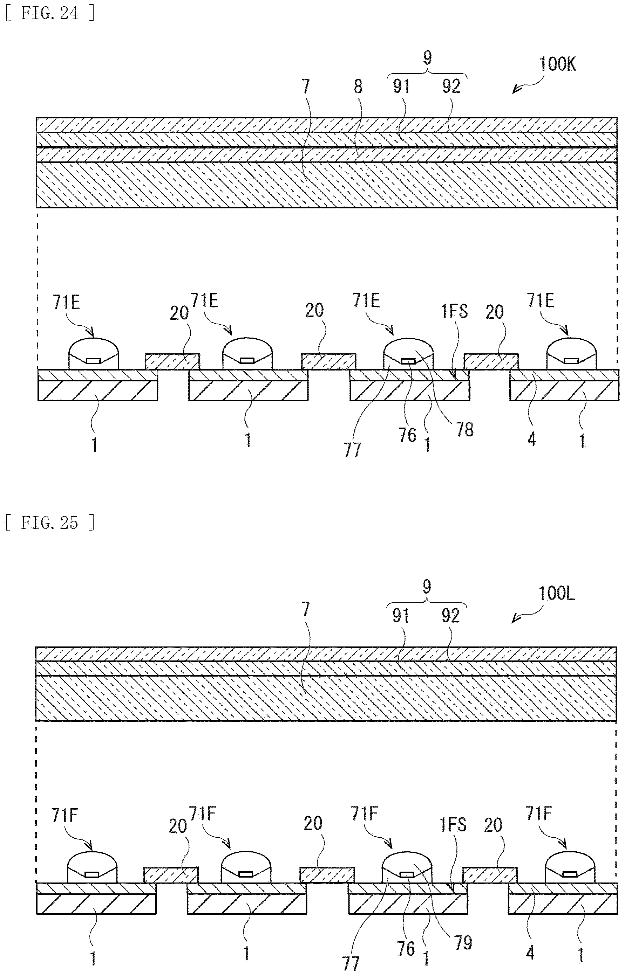

According to a light emitting device 100K, illustrated in FIG. 24 as a modification example 3-5 of the present disclosure, light emitting elements 71E, each of which is including the sealing material 78 in a shape of dome, are provided. The configuration of the light emitting element 71E is substantially the same as the configuration of the light emitting element 71C, except that a shape of the sealing material 78 is different. According to the light emitting element 71E, because the sealing material 78 is in the shape of dome, it is possible to equip the sealing material 78 with lens functions. Thus, a desired orientation performance may be accomplished easily.

### [3.6 Modification Example 3-6]

According to a light emitting device 100L, illustrated in FIG. 25 as a modification example 3-6 of the present disclosure, light emitting elements 71F, each of which is including a sealing material 99 in a shape of dome, is provided. The configuration of the light emitting element 71F is substantially the same as the configuration of the light emitting element 71D, except that a shape of the sealing material 78 is different. Specifically, the light emitting element 71F includes, the light emitting layer 76 configured by, for example, a blue LED, the base 77, and the sealing material 79 made by transparent resin containing wavelength conversion members. According to the light emitting element 71F, because the sealing material 79 is in the shape of dome, it is possible to equip the sealing material 79 with lens functions. Thus, a desired orientation performance may be accomplished easily.

### [3.7 Modification Example 3-7]

According to the second embodiment described above, although the explanation has been made with reference to the display device 101 provided with the liquid crystal panel 122 as the example, the present disclosure is not limited to this configuration. Thus, although the display device 101 is configured to use the light emitting device 100 as a backlight of the liquid crystal panel 122, the light emitting device 100 may also be used as a display panel.

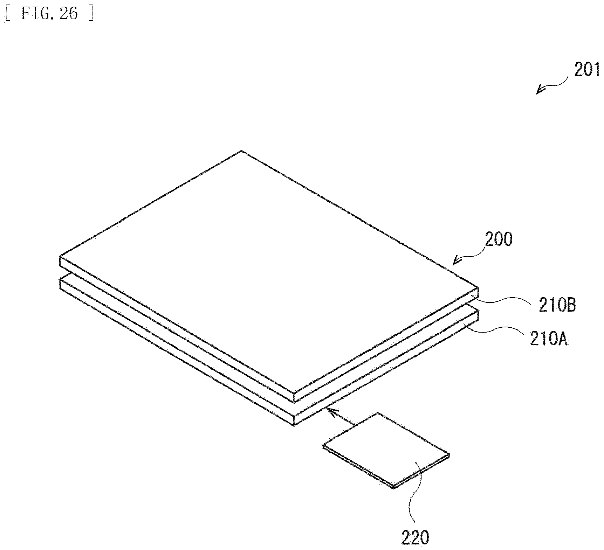

FIG. 26 schematically illustrates a display device 201 provided with a display panel 200. The display device 201 is provided with a display panel 210, and a control circuit 220 for driving and controlling the display panel 210. The display device 201 is a so-called LED display, in which LEDs are used as display pixels. Thus, the light source 2 of the light emitting device 100 is configured to be used as the display pixel. The display panel 210 is configured by joining a mounting substrate 210A including the light emitting device 100, and an opposite-side substrate 210B, with each other. A front surface of the opposite-side substrate 210B (a surface on a side opposing to the mounting substrate 210A) is an image display surface, having a display region at a center, of which periphery includes a frame region as a non-display region. The opposite-side substrate 210B is disposed at a position opposite to the mounting substrate 210A, for example, with a predetermined space. Note that, the opposite-side substrate 210B may be in contact with an upper surface of the mounting substrate 210A. The opposite-side substrate 210B includes, for example, a light transmitting substrate which transmits visible light, and includes, for example, a glass substrate, a transparent resin substrate, or a transparent resin film.

It should be noted that the effects described in this specification are only exemplified effects, and effects of the present disclosure are not limited to the effects described herein, and the present disclosure may have effects other than the effects described herein. For example, the light source is not limited to either a white light source or a blue-light source, and the light source emitting another color, for example, a green-light source or a red-light source, may be used. Moreover, the present disclosure may also be configured as follows.
<1> A light emitting device including:
   multiple light source units each including one light source substrate and one or more light sources provided on the light source substrate; and
   one relay sheet member supporting each of the multiple light source units, the one relay sheet member being electrically coupled to each of the multiple light source units.
<2> The light emitting device according to <1>, in which one or more wirings are formed on the one relay sheet member.
<3> The light emitting device according to <2>, further including
   a conductive material for electrically coupling the multiple light source units and the wirings of the one relay sheet member to each other.
<4> The light emitting device according to any one of <1> to <3>, in which the multiple light source units are separated from each other.
<5> The light emitting device according to any one of <1> to <4>, in which one or both of the light source substrate and the one relay sheet member have flexibility.
<6> The light emitting device according to any one of <1> to <5>, in which
   the one light source substrate in each of the multiple light source units includes a first surface on a side through which light from the one or more light sources is emitted, and a second surface on a side opposite to the first surface, and
   the one relay sheet member is joined to the first surface of the one light source substrate in each of the multiple light source units.
<7> The light emitting device according <6>, in which
   the one relay sheet member includes a plurality of apertures, and
   the plurality of apertures is provided at a position overlapping with the one or more light sources in each of the multiple light source units in a thickness direction orthogonal to the first surface.
<8> The light emitting device according <7>, in which the one relay sheet member includes a reflective layer reflecting light from the one or more light sources in each of the multiple light source units.
<9> The light emitting device according to any one of <6> to <8>, further including
   one protection sheet member joined to the second surface of the one light source substrate in each of the multiple light source units.
<10> The light emitting device according to <9>, in which all of the light source substrate, the one relay sheet member, and the one protection sheet member have flexibility.
<11> The light emitting device according to <9> or <10>, in which the one relay sheet member includes a reflective layer reflecting light from the one or more light sources in each of the multiple light source units.
<12> The light emitting device according to any one of <1> to <5>, in which
   the one light source substrate in each of the multiple light source units includes a first surface on a side through which light from the one or more light sources is emitted, and a second surface on a side opposite to the first surface, and
   the one relay sheet member is joined to the second surface of the one light source substrate in each of the multiple light source units.
<13> The light emitting device according to any one of <1> to <12>, further including
   a driver that drives the one or more light sources in each of the multiple light source units.
<14> The light emitting device according to <13>, in which the driver is mounted on one or both of the one relay sheet member and the one light source substrate.
<15> The light emitting device according to <13> or <14>, in which the driver is mounted on the one light source substrate in at least one of the multiple light source units, the driver driving the one or more light sources provided on the one light source substrate on which the driver is mounted.
<16> The light emitting device according to any one of <13> to <15>, in which
   the multiple light source units include a first light source unit and a second light source unit, and
   the driver is mounted on the relay sheet member, and is configured to drive both of one or more light sources provided on the first light source unit and one or more light sources provided on the second light source unit.
<17> The light emitting device according to any one of <1> to <16>, in which each of the light sources are each a white light source, or include a red-light source, a green-light source, and a blue-light source.
<18> The light emitting device according to any one of <1> to <17>, further including
   a wavelength conversion member, in which
   the light source includes a light emitting element emitting blue light, and
   the wavelength conversion member converts blue light from the light emitting element into white light.
<19> The light emitting device according to <18>, in which the wavelength conversion member includes quantum dots.
<20> A display device comprising:
   a light emitting device; and
   a display panel performing image display by using light from the light emitting device, wherein
   the light emitting device includes
   multiple light source units each including one light source substrate and one or more light sources provided on the light source substrate, and
   one relay sheet member supporting each of the multiple light source units, the one relay sheet member being electrically coupled to each of the multiple light source units.
<21> The light emitting device according to any one of <1> to <19>, further including
   multiple coupling parts electrically coupling the multiple light source units and the relay sheet member to each other, in which
   the multiple light source units and the relay sheet member overlap with each other at the multiple coupling parts in a thickness direction of the light source substrate, and
   the coupling part includes a bump formed on either one of the light source unit or the relay sheet member; a pad formed on another of the light source unit or the relay sheet member and opposing to the bump in the thickness direction, and a conductive material sandwiched between the bump and the pad.

The present application claims the benefit of Japanese Priority Patent Application JP2023-012930 filed with the Japan Patent Office on January 31, 2023, the entire contents of which are incorporated herein by reference.

It should be understood by those skilled in the art that various modifications, combinations, sub-combinations and alterations may occur depending on design requirements and other factors insofar as they are within the scope of the appended claims or the equivalents thereof.

## Claims

1. A light emitting device including:
multiple light source units each including one light source substrate and one or more light sources provided on the light source substrate; and
one relay sheet member supporting each of the multiple light source units, the one relay sheet member being electrically coupled to each of the multiple light source units.

2. The light emitting device according to claim 1, wherein one or more wirings are formed on the one relay sheet member.

3. The light emitting device according to claim 2, further including
a conductive material for electrically coupling the multiple light source units and the wirings of the one relay sheet member to each other.

4. The light emitting device according to claim 1, wherein the multiple light source units are separated from each other.

5. The light emitting device according to claim 1, wherein one or both of the light source substrate and the one relay sheet member have flexibility.

6. The light emitting device according to claim 1, wherein
the one light source substrate in each of the multiple light source units includes a first surface on a side through which light from the one or more light sources is emitted, and a second surface on a side opposite to the first surface, and
the one relay sheet member is joined to the first surface of the one light source substrate in each of the multiple light source units.

7. The light emitting device according to claim 6, wherein
the one relay sheet member includes a plurality of apertures, and
the plurality of apertures is provided at a position overlapping with the one or more light sources in each of the multiple light source units in a thickness direction orthogonal to the first surface.

8. The light emitting device according to claim 7, wherein the one relay sheet member includes a reflective layer reflecting light from the one or more light sources in each of the multiple light source units.

9. The light emitting device according to claim 6, further including
one protection sheet member joined to the second surface of the one light source substrate in each of the multiple light source units.

10. The light emitting device according to claim 9, wherein all of the light source substrate, the one relay sheet member, and the one protection sheet member have flexibility.

11. The light emitting device according to claim 9, wherein the one relay sheet member includes a reflective layer reflecting light from the one or more light sources in each of the multiple light source units.

12. The light emitting device according to claim 1, wherein
the one light source substrate in each of the multiple light source units includes a first surface on a side through which light from the one or more light sources is emitted, and a second surface on a side opposite to the first surface, and
the one relay sheet member is joined to the second surface of the one light source substrate in each of the multiple light source units.

13. The light emitting device according to claim 1, further including
a driver that drives the one or more light sources in each of the multiple light source units.

14. The light emitting device according to claim 13, wherein the driver is mounted on one or both of the one relay sheet member and the one light source substrate.

15. The light emitting device according to claim 13, wherein the driver is mounted on the one light source substrate in at least one of the multiple light source units, the driver driving the one or more light sources provided on the one light source substrate on which the driver is mounted.

16. The light emitting device according to claim 13, wherein
the multiple light source units include a first light source unit and a second light source unit, and
the driver is mounted on the relay sheet member, the driver being configured to drive both of one or more light sources provided on the first light source unit and one or more light sources provided on the second light source unit.

17. The light emitting device according to claim 1, wherein the light sources are each a white light source, or include a red-light source, a green-light source, and a blue-light source.

18. The light emitting device according to claim 1, further including
a wavelength conversion member, wherein
the light source includes a light emitting element emitting blue light, and
the wavelength conversion member converts blue light from the light emitting element into white light.

19. The light emitting device according to claim 18, wherein the wavelength conversion member includes quantum dots.

20. A display device comprising:
a light emitting device; and
a display panel performing image display by using light from the light emitting device, wherein
the light emitting device includes
multiple light source units each including a light source substrate and one or more light sources provided on the light source substrate, and
one relay sheet member supporting each of the multiple light source units, the one relay sheet member being electrically coupled to each of the multiple light source units.

21. The light emitting device according to claim 1, further including
multiple coupling parts electrically coupling the multiple light source units and the relay sheet member to each other, wherein
the multiple light source units and the relay sheet member overlap with each other at the multiple coupling parts in a thickness direction of the light source substrate, and
the multiple coupling parts each include a bump formed on either one of the light source unit or the relay sheet member, a pad formed on another of the light source unit or the relay sheet member and opposing to the bump in the thickness direction, and a conductive material sandwiched between the bump and the pad.
